# EUROPEAN PATENT APPLICATION

(11) **EP 1 453 081 A1**
(43) Date of publication of application: **01.09.2004**
(21) Application number: 02788744.7
(22) Date of filing: 06.12.2002
(51) Int. Cl.: H01L 21/304

(54) **SUBSTRATE HOLDING DEVICE AND POLISHING DEVICE**

(30) Priority: 06.12.2001 JP 2001372771; 12.12.2001 JP 2001379337
(71) Applicant: EBARA CORPORATION, Ohta-ku, Tokyo 144-8510 (JP)
(72) Inventor: TOGAWA, Tetsuji, Ebara Corporation, Tokyo 144-8510 (JP); NABEYA, Osamu, Ebara Corporation, Tokyo 144-8510 (JP); FUKUSHIMA, Makoto, Ebara Corporation, Tokyo 144-8510 (JP); SAKURAI, Kunihiko, Ebara Corporation, Tokyo 144-8510 (JP); YOSHIDA, Hiroshi, Ebara Corporation, Tokyo 144-8510 (JP); ICHIMURA, Teruhiko, Ebara Corporation, Tokyo 144-8510 (JP)
(74) Representative: Wagner, Karl H., Dipl.-Ing.
(86) International application number: PCT/JP2002/012816
(87) International publication number: WO 2003/049168

(57) **Abstract**

The present invention relates to a substrate holding apparatus for holding a substrate (W) such as a semiconductor wafer in a polishing apparatus for polishing the substrate to a flat finish. A substrate holding apparatus according to the present invention comprises a top ring body (2) having a receiving space therein, and a vertically movable member (206) which is vertically movable within the receiving space in the top ring body. An abutment member (209) having an elastic membrane is attached to a lower surface of the vertically movable member. The elastic membrane (291) of the abutment member comprises an abutment portion (291b), having a flange (291a) projecting outwardly, brought into direct or indirect contact with the substrate, and a connecting portion (291c) extending upwardly from a base portion (291d) of the flange of the abutment portion and being connected to the vertically movable member. The connecting portion is made of a material having a flexibility higher than the abutment portion.

## Description

### Technical Field

The present invention relates to a substrate holding apparatus for holding a substrate to be polished and pressing the substrate against a polishing surface, and more particularly to a substrate holding apparatus for holding a substrate such as a semiconductor wafer in a polishing apparatus for polishing the substrate to a flat finish. The present invention also relates to a polishing apparatus having such a substrate holding apparatus.

### Background Art

In recent years, semiconductor devices have become more integrated, and structures of semiconductor elements have become more complicated. Further, the number of layers in multilayer interconnections used for a logical system has been increased. Accordingly, irregularities on a surf ace of a semiconductor device become increased, so that step heights on the surface of the semiconductor device tend to be larger. This is because, in a manufacturing process of a semiconductor device, a thin film is formed on a semiconductor device, then micromachining processes, such as patterning or forming holes, are performed on the semiconductor device, and these processes are repeated many times to form subsequent thin films on the semiconductor device.

When the number of irregularities is increased on a surface of a semiconductor device, the following problems arise. The thickness of a film formed in a portion having a step is relatively small when a thin film is formed on a semiconductor device. An open circuit is caused by disconnection of interconnections, or a short circuit is caused by insufficient insulation between interconnection layers. As a result, good products cannot be obtained, and the yield tends to be reduced. Further, even if a semiconductor device initially works normally, reliability of the semiconductor device is lowered after a long-term use. At the time of exposure in a lithography process, if the irradiation surface has irregularities, then a lens unit in an exposure system is locally unfocused. Therefore, if the irregularities of the surface of the semiconductor device are increased, then it becomes problematic that it is difficult to form a fine pattern itself on the semiconductor device.

Accordingly, in a manufacturing process of a semiconductor device, it increasingly becomes important to planarize a surface of the semiconductor device. The most important one of the planarizing technologies is CMP (Chemical Mechanical Polishing) . In the chemical mechanical polishing, with use of a polishing apparatus, while a polishing liquid containing abrasive particles such as silica (SiO2) therein is supplied onto a polishing surface such as a polishing pad, a substrate such as a semiconductor wafer is brought into sliding contact with the polishing surface, so that the substrate is polished.

This type of polishing apparatus comprises a polishing table having a polishing surface constituted by a polishing pad, and a substrate holding apparatus, which is called as a top ring or a carrier head, for holding a semiconductor wafer. When a semiconductor wafer is polished with such a polishing apparatus, the semiconductor wafer is held and pressed against the polishing table under a predetermined pressure by the substrate holding apparatus. At this time, the polishing table and the substrate holding apparatus are moved relatively to each other to bring the semiconductor wafer into sliding contact with the polishing surface, so that the surface of the semiconductor wafer is polished to a flat mirror finish.

In such a polishing apparatus, if a relative pressing force between the semiconductor wafer being polished and the polishing surface of the polishing pad is not uniform over an entire surface of the semiconductor wafer, then the semiconductor wafer may insufficiently be polished or may excessively be polished at some portions depending on the pressing force applied to those portions of the semiconductor wafer. Therefore, it has been attempted to form a surface, for holding a semiconductor wafer, of a substrate holding apparatus by an elastic membrane made of an elastic material such as rubber and to supply fluid pressure such as air pressure to a backside surface of the elastic membrane to unformize pressing forces applied to the semiconductor wafer over an entire surface of the semiconductor wafer.

Further, the polishing pad is so elastic that pressing forces applied to a peripheral portion of the semiconductor wafer being polished become non-uniform, and hence only the peripheral portion of the semiconductor wafer may excessively be polished, which is referred to as "edge rounding". In order to prevent such edge rounding, there has been used a substrate holding apparatus in which a semiconductor wafer is held at its peripheral portion by a guide ring or a retainer ring, and the annular portion of the polishing surface that corresponds to the peripheral portion of the semiconductor wafer is pressed by the guide ring or retainer ring.

The thickness of a thin film formed on a surface of a semiconductor wafer varies from position to position in a radial direction of the semiconductor wafer depending on a film deposition method or characteristics of a film deposition apparatus. Specifically, the thin film has a film thickness distribution in the radial direction of the semiconductor wafer. Since a conventional substrate holding apparatus, as described above, for uniformly pressing an entire surface of a semiconductor wafer polishes the semiconductor wafer uniformly over the entire surface thereof, it cannot realize apolishing amount distribution that is equal to the aforementioned film thickness distribution on the surface of the semiconductor wafer. Therefore, the conventional polishing apparatus cannot sufficiently cope with the film thickness distribution in the radial direction, and insufficient or excessive polishing is caused.

Further, the aforementioned film thickness distribution on the surface of the semiconductor wafer varies depending on the type of a filmdepositionmethodor a filmdeposition apparatus. Specifically, positions and the number of portions having a large film thickness in a radial direction and differences in thickness between thin film portions and thick film portions vary depending on the type of a film deposition method or a film deposition apparatus. Therefore, a substrate holding apparatus capable of easily coping with various film thickness distributions at low cost has been required rather than a substrate holding apparatus capable of coping with only a specific film thickness distribution.

In a substrate holding apparatus having a structure for pressing a portion of a polishing surface that corresponds to a peripheral portion of a semiconductor wafer by a guide ring or retainer ring in order to prevent edge rounding, non-uniform polishing such as edge rounding cannot sufficiently be suppressed in some cases by merely controlling pressing forces of the aforementioned guide ring or retainer ring. Generally, no devices are formed on a peripheral portion of a semiconductor wafer. Nevertheless, for the purpose of preventing elution of metal or other defects, it is required that a polishing rate is intentionally reduced at a peripheral portion of a semiconductor wafer so that anunderlayer filmis not exposed, or, on the contrary, a polishing rate is intentionally increased at a peripheral potion of a semiconductor wafer so as to remove a film on the peripheral potion of the semiconductor wafer. A conventional polishing apparatus cannot sufficiently control a polishing rate at a peripheral potion of a semiconductor wafer to a desired level.

### Disclosure of Invention

The present invention has been made in view of the above prior art. It is, therefore, a first object of the present invention to provide a substrate holding apparatus and a polishing apparatus which can polish a thin film, formed on a surface of a workpiece such as a semiconductor wafer, having a film thickness distribution and can obtain a uniform film thickness after polishing.

Further, the present invention has been made in view of the above prior art in which a polishing rate at a peripheral portion of a workpiece cannot sufficiently be controlled to a desired level. It is, therefore, a second object of the present invention to provide a substrate holding apparatus and a polishing apparatus which can uniformly polish a workpiece such as a semiconductor wafer with controlling a polishing rate at a peripheral portion of the workpiece to a desired level.

In order to attain the first object, according to a first aspect of the present invention, there is provided a substrate holding apparatus for holding and pressing a substrate to be polished against a polishing surface, characterized in that: the substrate holding apparatus comprises a top ring body having a receiving space therein, and a vertically movable member which is vertically movable within the receiving space in the top ring body; an abutment member having an elastic membrane is attached to a lower surface of the vertically movable member; the elastic membrane of the abutment member comprises an abutment portion, having a flange projecting outwardly, brought into direct or indirect contact with the substrate, and a connecting portion extending upwardly from a base portion of the flange of the abutment portion and being connected to the vertically movable member; and the connecting portion is made of a material having a flexibility higher than the abutment portion.

With this arrangement, pressures to be applied to the substrate can independently be controlled, and hence a pressing force applied to a thicker area of a thin film can be made higher than a pressing force applied to a thinner area of the thin film, thereby selectively increasing the polishing rate of the thicker area of the thin film. Thus, an entire surface of a substrate can be polished exactly to a desired level irrespective of the film thickness distribution obtained at the time the thin film is formed. Further, even if the vertically movable member is pressed downwardly for polishing, excessive downward forces are not applied to the substrate which is brought into close contact with the abutment portion because the connecting portion is elastically deformed, so that a uniform polishing rate can be achieved in an area between the base portions of the flanges. Further, even if a vertically movable member is lifted for polishing, excessive upward forces are not applied to the abutment portion because the connecting portion is likely to extend, so that a vacuum is not formed near the base portions of the flanges to achieve a uniform polishing rate in an area between the base portions.

According to a second aspect of the present invention, there is provided a substrate holding apparatus for holding and pressing a substrate to be polished against a polishing surface, characterized in that: the substrate holding apparatus comprises a top ring body having a receiving space therein, and a vertically movable member which is vertically movable within the receiving space in the top ring body; an abutment member having an elastic membrane is attached to a lower surface of the vertically movable member; the elastic membrane of the abutment member comprises an abutment portion, having a flangeprojectingoutwardly, brought into direct or indirect contact with the substrate, and a connecting portion extending upwardly from a base portion of the flange of the abutment portion and being connected to the vertically movable member; and the connecting portion comprises a thin portion having a thickness smaller than the abutment portion.

With this arrangement, an entire surface of a substrate can be polished exactly to a desired level irrespective of the film thickness distribution obtained at the time the thin film is formed. Simultaneously, even if the vertically movable member is pressed downwardly for polishing, excessive downward forces are not applied to the substrate which is brought into close contact with the abutment portion because the connecting portion is likely to be deformed at the thin portion, so that a uniform polishing rate can be achieved in an area between the base portions of the flanges. Further, even if the vertically movable member is lifted for polishing, excessive upward forces are not applied to the abutment portion because the thin portion is likely to extend, so that a vacuum is not formed near the base portions of the flanges to achieve a uniform polishing rate in an area between the base portions. Particularly, when the thin portion is formed so as to be constricted inwardly in a cross-section, these effects can effectively be achieved.

According to a third aspect of the present invention, there is provided a substrate holding apparatus for holding and pressing a substrate to be polished against a polishing surface, characterized in that: the substrate holding apparatus comprises a top ring body having a receiving space therein, and a vertically movable member which is vertically movable within the receiving space in the top ring body; an abutment member having an elastic membrane is attached to a lower surface of the vertically movable member; the elastic membrane of the abutment member comprises an abutment portion, having a flange proj ectingoutwardly, brought into direct or indirect contact with the substrate, and a connecting portion extending upwardly from a base portion of the flange of the abutment portion and being connected to the vertically movable member; and adhesiveness of a lower surface of the base portion of the flange of the abutment portion is weakened.

With this arrangement, an entire surface of a substrate can be polished exactly to a desired level irrespective of the film thickness distribution obtained at the time the thin film is formed. Simultaneously, even if the vertically movable member is lifted for polishing, a vacuum is unlikely to be formed near the base portion of the flange because the base portion of the flange is unlikely to be brought into close contact with the substrate. Therefore, a uniform polishing rate can be achieved in an area between the base portions.

In this case, an intermediate member having a low adhesiveness to the substrate may be disposed on the lower surface of the base portion of the flange of the abutment portion to weaken adhesiveness of the lower surface of the base portion of the flange. Alternatively, adhesiveness between the base portion of the flange and the substrate may be weakened by, for example, forming a groove in the lower surface of the base portion of the flange, or by forming the lower surface of the base portion as a rough surface.

According to a fourth aspect of the present invention, there is provided a substrate holding apparatus for holding and pressing a substrate to be polished against a polishing surface, characterized in that: the substrate holding apparatus comprises a top ring body having a receiving space therein, and a vertically movable member which is vertically movable within the receiving space in the top ring body; an abutment member having an elastic membrane is attached to a lower surface of the vertically movable member; the elastic membrane of the abutment member comprises an abutment portion, having a flange proj ecting outwardly, brought into direct or indirect contact with the substrate, and a connecting portion extending upwardly from a base portion of the flange of the abutment portion and being connected to the vertically movable member; and a hard member made of a material harder than the elastic membrane is embedded in the base portions of the flange of the abutment portion. In this case, the hard member should preferably have an annular shape.

With this arrangement, an entire surface of a substrate can be polished exactly to a desired level irrespective of the film thickness distribution obtained at the time the thin film is formed. Simultaneously, even if the verticallymovable member is downwardly pressed for polishing, excessive downward forces are not applied to the substrate which is brought into close contact with the abutment portion because downward forces by the connecting portion are dispersed by the hard member, so that a uniform polishing rate can be achieved in an area between the base portions. Further, even if the vertically movable member is lifted for polishing, a vacuum is not formed near the base portion of the flange because the hard member prevents deformation of the vicinity of the base portion of the flange. Therefore, a uniform polishing rate can be achieved in an area between the base portions.

According to a fifth aspect of the present invention, there is provided a substrate holding apparatus for holding and pressing a substrate to be polished against a polishing surface, characterized in that: the substrate holding apparatus comprises a top ring body having a receiving space therein, and a vertically movable member which is vertically movable within the receiving space in the top ring body; an abutment member having an elastic membrane is attached to a lower surface of the vertically movable member; and the elastic membrane of the abutment member comprises an abutment portion, having a flange proj ecting outwardly, brought into direct or indirect contact with the substrate, an extending portion extending outwardly from a base portion of the flange to a position inward of a tip of the flange to form a groove between the extending portion and the flange of the abutment portion, and a connecting portion extending upwardly from an outward end of the extending portion and being connected to the vertically movable member.

With this arrangement, an entire surface of a substrate can be polished exactly to a desired level irrespective of the film thickness distribution obtained at the time the thin film is formed. Further, in a case where the vertically movable member is lifted for polishing after the substrate is brought into close contact with the abutment portion, upward forces by the connecting portion are converted into forces in horizontal or oblique directions by the extending portion, and the converted forces are applied to the base portion of the flange. Therefore, upward forces applied to the base portion of the flange can be made extremely small, so that excessive upward forces are not applied to the abutment portion. Accordingly, a vacuum is not formed near the base portion, so that a uniform polishing rate can be achieved in an area between the base portions.

According to a preferred aspect of the present invention, the connecting portion positioned radially inwardly and the connecting portion positioned radially outwardly have different thicknesses. In this case, it is desirable that the connecting portion positioned radially inwardly has a thickness smaller than the connecting portion positioned radially outwardly.

According to a preferred aspect of the present invention, the flange proj ecting radially outwardly and the flange proj ecting radially inwardly have different lengths. In this case, it is desirable that the flange projecting radially outwardly has a length larger than the flange projecting radially inwardly.

Because a cylinder having a smaller curvature generally has a stiffness larger than a cylinder having a larger curvature, a vertical force applied to the base portion of the flange by the connecting portion positioned radially inwardly becomes larger than a force applied to the base portion of the flange by the connecting portion positioned radially outwardly. Therefore, with the above arrangement, forces applied to the base portions of the flange positioned radially inwardly and the flange positioned radially outwardly can be adjusted to the same level, or a sealing capability can be enhanced at the flange projecting radially outwardly, so that a uniform polishing rate can be achieved in an area between the base portions.

According to a sixth aspect of the present invention, there is provided a substrate holding apparatus for holding and pressing a substrate to be polished against a polishing surface, characterized in that: the substrate holding apparatus comprises a top ring body having a receiving space therein, and a vertically movable member which is vertically movable within the receiving space in the top ring body; an abutment member having an elastic membrane which is brought into direct or indirect contact with the substrate is attached to a lower surface of the vertically movable member; and the vertically movable member is made of a material having a large stiffness.

With this arrangement, when the vertically movable member is made of a material having a large stiffness and a light weight, e.g., epoxy resin, the vertically movable member becomes unlikely to be bent, so that polishing rates are prevented frombeing locally increased. Further, when a material having no magnetism is selected as a material of the vertically movable member, the film thickness of a thin film formed on a surface of a semiconductor wafer can be measured with a film thickness method using eddy current in such a state that the semiconductor wafer to be polished is held.

According to a seventh aspect of the present invention, there is provided a substrate holding apparatus for holding and pressing a substrate to be polished against a polishing surface, characterized in that: an abutment member having an elastic membrane is attached to a lower surface of a top ring; the elastic membrane of the abutment member comprises an abutment portion, having a flange projecting outwardly, brought into direct or indirect contact with the substrate, and a connecting portion extending upwardly from a base portion of the flange of the abutment portion and being connected to the top ring; and the top ring has a support portion for supporting the flange of the abutment member.

With this arrangement, an entire surface of a substrate can be polished exactly to a desired level irrespective of the film thickness distribution obtained at the time the thin film is formed. Simultaneously, when a pressurized fluid is supplied into a space around the abutment member, the flange is prevented from being deformed and attached to a lower surface of the top ring, thereby achieving stable polishing.

In this case, it is desirable that the support portion has a radial length larger than a radial length of the flange of the abutment member. With such a support portion, the flange of the abutment member can be supportedmore reliably, so that more stable polishing can be achieved.

According to a preferred aspect of the present invention, a fluid introduction groove for introducing a fluid into an upper surface of the flange of the abutment member is formed in the support portion. With this arrangement, since a pressurized fluid can be introduced into the upper surface of the flange, adhesiveness of the flange to the substrate can be enhanced to achieve stable polishing.

According to an eighth aspect of the present invention, there is provided a substrate holding apparatus for holding and pressing a substrate to be polished against a polishing surface, characterized in that: the substrate holding apparatus comprises a top ring body having a receiving space therein, a vertically movable member which is vertically movable within the receiving space in the top ring body, and a seal ring being brought into contact with an upper surface of a peripheral portion of the substrate; and the vertically movable member has a support portion for supporting the seal ring, the support portion having a radial length in a range of from 1 mm to 7 mm.

With this arrangement, entire surface of a substrate can be polished exactly to a desired level irrespective of the film thickness distribution obtained at the time the thin film is formed. Simultaneously, when a pressurized fluid is supplied into a space around the seal ring, the seal ring isprevented frombeing deformed and attached to a lower surface of the vertically movable member. Further, a peripheral portion of the substrate is likely to be excessively polished. However, when the support portion has a radial length in a range of from 1 mm to 7 mm, it is possible to prevent the excessive polishing.

According to a preferred aspect of the present invention, a fluid introduction groove for introducing a fluid into an upper surface of the seal ring is formed in the support portion of the vertically movable member. With this arrangement, since a pressurized fluid can be introduced into the upper surface of the seal ring, adhesiveness of the seal ring to the substrate can be enhanced to achieve stable polishing.

In order to attain the second object, according to a ninth aspect of the present invention, there is provided a substrate holding apparatus for holding and pressing a substrate to be polished against a polishing surface, characterized in that: the substrate holding apparatus comprises a top ring body for holding the substrate, an edge bag being brought into contact with a peripheral portion of the substrate, a torque transmitting member being brought into contact with the substrate radially inwardly of the edge bag; and a pressure of a first pressure chamber defined in the edge bag and a pressure of a second pressure chamber defined radially inwardly of the edge bag are independently controlled.

With this arrangement, sufficient torque can be transmitted to the substrate by the torque transmitting member. Further, the entire surface of the substrate except the peripheral portion thereof can be pressed against the polishing surface at a uniform force by the pressure of the second pressure chamber, and the pressure of the first pressure chamber can be controlled independently of the pressure of the second pressure chamber. Therefore, it is possible to control a polishing rate at the peripheral portion of the substrate, i.e., a polishing profile of the peripheral portion of the substrate.

According to a preferred aspect of the present invention, the torque transmitting member has a communication hole communicating a space inside of the torque transmitting member and a space outside of the torque transmitting member with each other.

Further, in view of controlling a polishing rate of a peripheral portion of the semiconductor wafer, it is desirable that the edge bag defining the first pressure chamber comprises a member having a radial width in a range of from 1 mm to 10 mm.

According to a preferred aspect of the present invention, the substrate holding apparatus comprises a retainer ring secured to or formed integrally with the top ring body for holding a side edge portion of the substrate; and a pressing force to press the retainer ring against the polishing surface is controlled independently of a pressure of the pressure chamber. In this manner, when the pressing force of the retainer ring is also controlled, more detailed control can be achieved.

A polishing apparatus according to the present invention comprises the aforementioned substrate holding apparatus and a polishing table having a polishing surface.

### Brief Description of Drawings

FIG. 1 is a cross-sectional view showing an entire arrangement of a polishing apparatus having a substrate holding apparatus according to the present invention;
FIG. 2 is avertical cross-sectional viewshowinga substrate holding apparatus according to a first embodiment of the present invention;
FIG. 3 is a bottom view of the substrate holding apparatus shown in FIG. 2;
FIG. 4 is a vertical cross-sectional view showing a first example of a ring tube in the substrate holding apparatus according to the first embodiment of the present invention;
FIG. 5 is a vertical cross-sectional view showing an elastic membrane of a ring tube shown in FIG. 4;
FIGS. 6A through 6C are vertical cross-sectional views showing deformation of the elastic membrane of the ring tube;
FIG. 7 is a vertical cross-sectional view showing a second example of an elastic membrane of a ring tube in a substrate holding apparatus according to the present invention;
FIG. 8 is a vertical cross-sectional view showing a third example of an elastic membrane of a ring tube in a substrate holding apparatus according to the present invention;
FIG. 9 is a vertical cross-sectional view showing a fourth example of an elasticmembrane of a ring tube in a substrate holding apparatus according to the present invention;
FIG. 10 is a vertical cross-sectional view showing a fifth example of an elasticmembrane of a ring tube in a substrate holding apparatus according to the present invention;
FIG. 11 is a vertical cross-sectional view showing a sixth example of an elasticmembrane of a ring tube in a substrate holding apparatus according to the present invention;
FIGS. 12A through 12C are vertical cross-sectional views showing a seventh example of an elastic membrane of a ring tube in a substrate holding apparatus according to the present invention;
FIG. 13 is a vertical cross-sectional view showing a substrate holding apparatus according to a second embodiment of the present invention;
FIG. 14 is a bottom view of the substrate holding apparatus shown in FIG. 13;
FIG. 15 is a vertical cross-sectional view showing a ring tube in the substrate holding apparatus according to the second embodiment of the present invention;
FIG. 16 is a vertical cross-sectional view showing a ring tube without any support portions in a chucking plate;
FIG. 17 is a partial perspective view showing a support portion of a chucking plate of FIG. 15;
FIG. 18 is a vertical cross-sectional view showing a seal ring without any support portions in a chucking plate;
FIG. 19 is a vertical cross-sectional view showing a seal ring in the substrate holding apparatus of FIG. 15;
FIG. 20 is a vertical cross-sectional view showing a substrate holding apparatus according to a third embodiment of the present invention;
FIG. 21 is a partial cross-sectional view showing an edge bag of FIG. 20; and
FIG. 22 is a partial cross-sectional view showing a torque transmitting member of FIG. 20.

### Best Mode for Carrying Out the Invention

A substrate holding apparatus and a polishing apparatus according to embodiments of the present invention will be described in detail below with reference to the drawings.

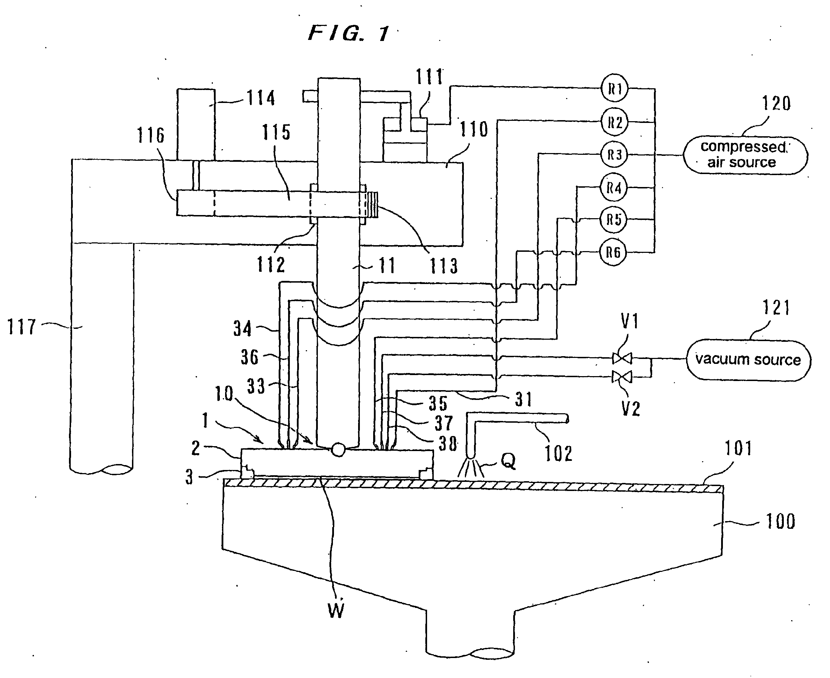

FIG. 1 is a cross-sectional view showing an entire arrangement of a polishing apparatus having a substrate holding apparatus according to the present invention. The substrate holding apparatus serves to hold a substrate such as a semiconductor wafer to be polished and to press the substrate against a polishing surface on a polishing table. As shown in FIG. 1, a polishing table 100 having a polishing pad 101 attached on an upper surface thereof is provided underneath a top ring 1 constituting a substrate holding apparatus according to the present invention. A polishing liquid supply nozzle 102 is provided above the polishing table 100, and a polishing liquid Q is supplied onto the polishing pad 101 on the polishing table 100 from the polishing liquid supply nozzle 102.

Various kinds of polishing pads are available on the market. For example, some of these are SUBA800, IC-1000, and IC-1000/SUBA400 (two-layer cloth) manufactured by Rodel Inc., and Surfin xxx-5 and Surfin 000 manufactured by Fujimi Inc. SUBA800, Surfin xxx-5, and Surfin 000 are non-woven fabrics bonded by urethane resin, and IC-1000 is made of rigid foam polyurethane (single-layer). Foam polyurethane is porous and has a large number of fine recesses or holes formed in its surface.

The top ring 1 is connected to a top ring drive shaft 11 by a universal joint 10, and the top ring drive shaft 11 is coupled to a top ring air cylinder 111 fixed to a top ring head 110. The top ring air cylinder 111 operates to move the top ring drive shaft 11 vertically to thereby lift and lower the top ring 1 as a whole and to press a retainer ring 3 fixed to a lower end of a top ring body 2 against the polishing table 100. The top ring air cylinder 111 is connected to a compressed air source 120 via a regulator R1, which can regulate pressure of compressed air or the like which is supplied to the top ring air cylinder 111. Thus, it is possible to adjust a pressing force to press the polishing pad 101 with the retainer ring 3.

The top ring drive shaft 11 is connected to a rotary sleeve 112 by a key (not shown). The rotary sleeve 112 has a timing pulley 113 fixedly disposed at a peripheral portion thereof. A top ring motor 114 is fixed to the top ring head 110, and the timing pulley 113 is coupled to a timing pulley 116 mounted on the top ring motor 114 via a timing belt 115. Therefore, when the top ring motor 114 is energized for rotation, the rotary sleeve 112 and the top ring drive shaft 11 are rotated in unison with each other via the timing pulley 116, the timing belt 115, and the timing pulley 113 to thereby rotate the top ring 1. The top ring head 110 is supported on a top ring head shaft 117 fixedly supported on a frame (not shown).

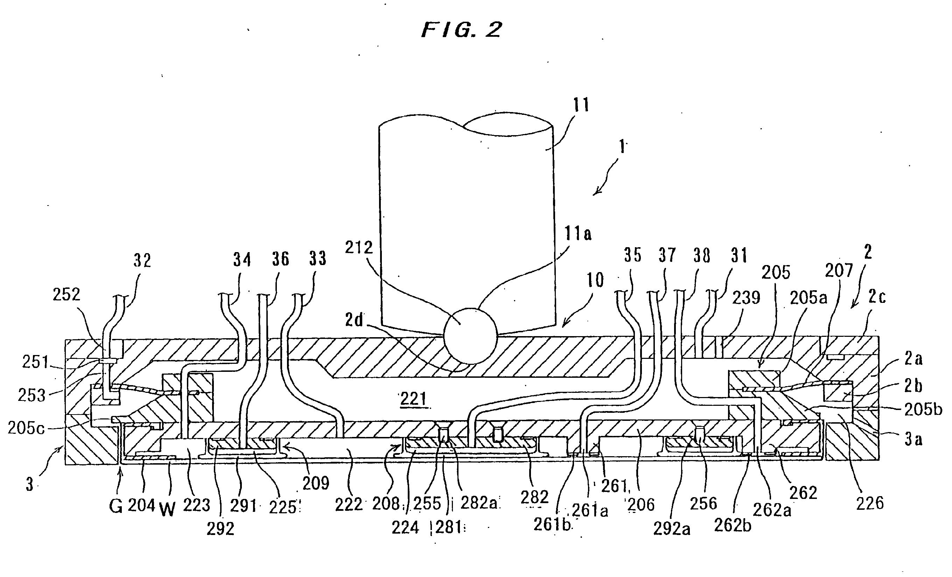

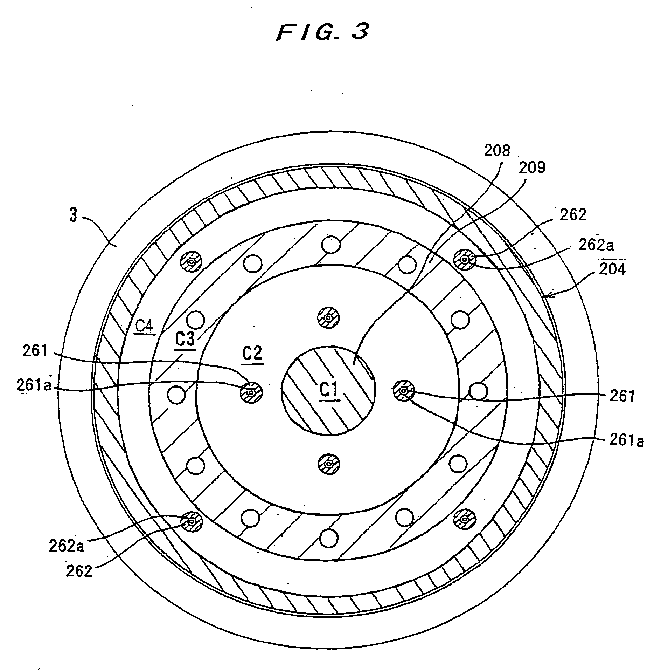

Next, a substrate holding apparatus according to a first embodiment of the present invention will be described below. FIG. 2 is a vertical cross-sectional view showing the top ring 1 of the substrate holding apparatus according to the first embodiment, and FIG. 3 is a bottom view of the top ring 1 shown in FIG. 2. As shown in FIG. 2, the top ring 1 constituting a substrate holding apparatus comprises a top ring body 2 in the form of a cylindrical housing with a receiving space defined therein, and a retainer ring 3 fixed to the lower end of the top ring body 2. The top ring body 2 is made of a material having high strength and rigidity, such as metal or ceramics. The retainer ring 3 is made of highly rigid synthetic resin, ceramics, or the like.

The top ring body 2 comprises a cylindrical housing 2a, an annular pressurizing sheet support 2b fitted into the cylindrical portion of the housing 2a, and an annular seal 2c fitted over an outer circumferential edge of an upper surface of the housing 2a. The retainer ring 3 is fixed to the lower end of the housing 2a of the top ring body 2. The retainer ring 3 has a lower portion projecting radially inwardly. The retainer ring 3 may be formed integrally with the top ring body 2.

The top ring drive shaft 11 is disposed above the central portion of the housing 2a of the top ring body 2, and the top ring body 2 is coupled to the top ring drive shaft 11 by the universal joint 10. The universal joint 10 has a spherical bearingmechanism by which the top ring body 2 and the top ring drive shaft 11 are tiltable with respect to each other, and a rotation transmitting mechanism for transmitting the rotation of the top ring drive shaft 11 to the top ring body 2. The spherical bearing mechanism and the rotation transmitting mechanism transmit a pressing force and a rotating force from the top ring drive shaft 11 to the top ring body 2 while allowing the top ring body 2 and the top ring drive shaft 11 to be tilted with respect to each other.

The spherical bearing mechanism comprises a hemispherical concave recess 11a defined centrally in the lower surface of the top ring drive shaft 11, a hemispherical concave recess 2d defined centrally in the upper surface of the housing 2a, and a bearing ball 212 made of a highly hard material such as ceramics and interposed between the concave recesses 11a and 2d. On the other hand, the rotation transmitting mechanism comprises drive pins (not shown) fixed to the top ring drive shaft 11, and driven pins (not shown) fixed to the housing 2a. Even if the top ring body 2 is tilted with respect to the top ring drive shaft 11, the drive pins and the driven pins remain in engagement with each other while contact points are displaced because the drive pin and the driven pin are vertically movable relatively to each other. Thus, the rotation transmitting mechanism reliably transmits rotational torque of the top ring drive shaft 11 to the top ring body 2.

The top ring body 2 and the retainer ring 3 secured to the top ring body 2 have a space defined therein, which accommodates therein a seal ring 204 having a lower surface brought into contact with a peripheral portion of the semiconductor wafer W held by the top ring 1, an annular holder ring 205, and a disk-shaped chuckingplate206 (verticallymovablemember) which is vertically movable within the receiving space in the top ring body 2. The seal ring 204 has a radially outer edge clamped between the holder ring 205 and the chucking plate 206 secured to the lower end of the holder ring 205 and extends radially inwardly so as to cover the lower surface of the chucking plate 206 near its outer circumferential edge. The lower end surface of the seal ring 204 is brought into contact with the upper surface of the semiconductor wafer W to be polished. The semiconductor wafer W has a recess defined in an outer edge thereof, which is referred to as a notch or orientation flat, for recognizing (identifying) the orientation of the semiconductor wafer. The seal ring 204 should preferably extend radially inwardly of the chucking plate 206 from the innermost position of such as a notch or orientation flat.

The chucking plate 206 may be made of metal. However, when the thickness of a thin film formed on a surface of a semiconductor wafer is measured by a method using eddy current in a state such that the semiconductor wafer to be polished is held by the top ring, the chucking plate 206 should preferably be made of a non-magnetic material, e.g., an insulating material such as fluororesin, epoxy resin, or ceramics.

A pressurizing sheet 207 comprising an elastic membrane extends between the holder ring 205 and the top ring body 2. The pressurizing sheet 207 has a radially outer edge clamped between the housing 2a and the pressurizing sheet support 2b of the top ring body 2, and a radially inner edge clamped between an upper end portion 205a and a stopper 205b of the holder ring 205. The top ring body 2, the chucking plate 206, the holder ring 205, and the pressurizing sheet 207 jointly define a pressure chamber 221 in the top ring body 2. As shown in FIG. 2, a fluid passage 31 comprising tubes and connectors communicates with the pressure chamber 221, which is connected to the compressed air source 120 via a regulator R2 provided on the fluid passage 31. The pressurizing sheet 207 is made of a highly strong and durable rubber material such as ethylene propylene rubber (EPDM), polyurethane rubber, or silicone rubber.

In the case where the pressurizing sheet 207 is made of an elastic material such as rubber, if the pressurizing sheet 207 is fixedly clamped between the retainer ring 3 and the top ring body 2, then a desired horizontal surface cannot be maintained on the lower surface of the retainer ring 3 because of elastic deformation of the pressurizing sheet 207 as an elastic material. In order to prevent such a drawback, the pressurizing sheet 207 is clamped between the housing 2a of the top ring body 2 and the pressurizing sheet support 2b provided as a separate member in the present embodiment. The retainer ring 3 may vertically be movable with respect to the top ring body 2, or the retainer ring 3 may have a structure capable of pressing the polishing surface independently of the top ring body 2. In such cases, the pressurizing sheet 207 is not necessarily fixed in the aforementioned manner.

A cleaning liquid passage 251 in the form of an annular groove is defined in the upper surface of the housing 2a near its outer circumferential edge over which the seal 2c of the top ring body 2 is fitted. The cleaning liquid passage 251 communicates with a fluid passage 32 via a through-hole 252 formed in the seal 2c, and is supplied with a cleaning liquid (pure water) via the fluid passage 32. A plurality of communication holes 253 are defined in the housing 2a and the pressurizing sheet support 2b in communication with the cleaning liquid passage 251. The communication holes 253 communicate with a small gap G defined between the outer circumferential surface of the seal ring 204 and the inner circumferential surface of the retainer ring 3.

A central bag 208 and a ring tube 209 which serve as abutment members brought into contact with the semiconductor wafer W are mounted in a space defined between the chucking plate 206 and the semiconductor wafer W. In the present embodiment, as shown in FIGS. 2 and 3, the central bag 208 is disposed centrally on the lower surface of the chucking plate 206, and the ring tube 209 is disposed radially outwardly of the central bag 208 in surrounding relation thereto. Each of the seal ring 204, the central bag 208, and the ring tube 209 is made of a highly strong and durable rubber material such as ethylene propylene rubber (EPDM), polyurethane rubber, or silicone rubber.

The space defined between the chucking plate 206 and the semiconductor wafer W is divided into a plurality of spaces by the central bag 208 and the ring tube 209. Accordingly, a pressure chamber 222 is defined between the central bag 208 and the ring tube 209, and a pressure chamber 223 is defined radially outwardly of the ring tube 209.

The central bag 208 comprises an elastic membrane 281 brought into contact with the upper surface of the semiconductor wafer W, and a central bag holder 282 for detachably holding the elastic membrane 281 in position. The central bag holder 282 has threaded holes 282a defined therein, and the central bag 208 is detachably fastened to the center of the lower surface of the chucking plate 206 by screws 255 threaded into the threaded holes 282a. The central bag 208 has a central pressure chamber 224 defined therein by the elastic membrane 281 and the central bag holder 282.

Similarly, the ring tube 209 comprises an elastic membrane 291 brought into contact with the upper surface of the semiconductor wafer W, and a ring tube holder 292 for detachably holding the elasticmembrane 291 in position. The ring tube holder 292 has threaded holes 292a defined therein, and the ring tube 209 is detachably fastened to the lower surface of the chucking plate 206 by screws 256 threaded into the threaded holes 292a. The ring tube 209 has an intermediate pressure chamber 225 defined therein by the elastic membrane 291 and the ring tube holder 292.

Inthepresent embodiment, the pressure chamber 224 is formed by the elastic membrane 281 of the central bag 208 and the central bag holder 282, and the pressure chamber 225 is formed by the elastic membrane 291 of the ring tube 209 and the ring tube holder 292. The pressure chambers 222, 223 may also be formed by an elastic membrane and a holder for fixing the elastic membrane, respectively. Further, elastic membranes and holders may appropriately be added to increase the number of the pressure chambers.

Fluid passages 33, 34, 35 and 36 comprising tubes and connectors communicate with the pressure chambers 222 and 223, the central pressure chamber 224, and the intermediate pressure chamber 225, respectively. The pressure chambers 222 to 225 are connected to the compressed air source 120 as a supply source via respective regulators R3, R4, R5 and R6 connected respectively to the fluid passages 33 to 36. The fluid passages 31 to 36 are connected to the respective regulators R1 to R6 through a rotary joint (not shown) mounted on the upper end of the top ring shaft 110.

The pressure chamber 221 above the chucking plate 206 and the pressure chambers 222 to 225 are supplied with pressurized fluids such as pressurized air or atmospheric air or evacuated, via the fluid passages 31, 33, 34, 35 and 36 connected to the respective pressure chambers. As shown in FIG. 1, the regulators R2 to R6 connected to the fluid passages 31, 33, 34, 35 and 36 of the pressure chambers 221 to 225 can respectively regulate the pressures of the pressurized fluids supplied to the respective pressure chambers. Thus, it is possible to independently control the pressures in the pressure chambers 221 to 225 or independently introduce atmospheric air or vacuum into the pressure chambers 221 to 225. In this manner, the pressures in the pressure chambers 221 to 225 are independently varied with the regulators R2 to R6, so that the pressing forces to press the semiconductor wafer W against the polishing pad 101 can be adjusted in local areas of the semiconductor wafer W. In some applications, the pressure chambers 221 to 225 may be connected to a vacuum source 121.

In this case, the pressurized fluid or the atmospheric air supplied to the pressure chambers 222 to 225 may independently be controlled in temperature. With this configuration, it is possible to directly control the temperature of a workpiece such as a semiconductor wafer from the backside of the surface to be polished. Particularly, when each of the pressure chambers is independently controlled in temperature, the rate of chemical reaction can be controlled in the chemical polishing process of CMP.

The chucking plate 206 has radially inner suction portions 261 extended downwardly therefrom between the central bag 208 and the ring tube 209. The chucking plate 206 has radially outer suction portions 262 extended downwardly therefrom outside of the ring tube 209. In the present embodiment, eight suction portions 261, 262 are provided.

The inner suctionportions 261 and the outer suction portions 262 have communication holes 261a, 262a communicating with fluid passages 37, 38, respectively. The inner suction portions 261 and the outer suction portions 262 are connected to the vacuum source 121 such as a vacuum pump via the fluid passages 37, 38 and valves V1, V2. When the communication holes 261a, 262a of the suction portions 261, 262 are connected to the vacuum source 121, a negative pressure is developed at the lower opening ends of the communication holes 261a, 262a thereof to attract a semiconductor wafer W to the lower ends of the inner suction portions 261 and the outer suctionportions 262. The inner suction portions 261 and the outer suctionportions 262 have elastic sheets 261b, 262b, such as thin rubber sheets, attached to their lower ends, for thereby elastically contacting and holding the semiconductor wafer W on the lower surfaces thereof.

Since there is a small gap G between the outer circumferential surface of the seal ring 204 and the inner circumferential surface of the retainer ring 3, the holder ring 205, the chucking plate 206, and the seal ring 204 attached to the chucking plate 206 can vertically be moved with respect to the top ring body 2 and the retainer ring 3, and hence are of a floating structure with respect to the top ring body 2 and the retainer ring 3. The stopper 205b of the holder ring 205 has a plurality of teeth 205c projecting radially outwardly from the outer circumferential edge thereof. Downward movement of the members including the holder ring 205 is limited to a predetermined range by engaging the teeth 205c with the upper surface of the radially inwardly projecting portion of the retainer ring 3.

Next, operation of the top ring 1 thus constructed will be described in detail below.

In the polishing apparatus constructed above, when a semiconductor wafer W is to be delivered to the polishing apparatus, the top ring 1 as a whole is moved to a position to which the semiconductor wafer W is transferred, and the communication holes 261a, 262a of the inner suction portions 261 and the outer suction portions 262 are connected via the fluid passages 37, 38 to the vacuum source 121. The semiconductor wafer W is attracted under vacuum to the lower ends of the inner suction portions 261 and the outer suction portions 262 by suction effect of the communication holes 261a, 262a. With the semiconductor wafer W attracted to the top ring 1, the top ring 1 as a whole is moved to a position above the polishing table 100 having the polishing surface (polishing pad 101) thereon. The outer circumferential edge of the semiconductor wafer W is held by the retainer ring 3 so that the semiconductor wafer W is not removed from the top ring 1.

For polishing the semiconductor wafer W, the attraction of semiconductor wafer W by the suction portions 261, 262 is released, and the semiconductor wafer W is heldon the lower surface of the top ring 1. Simultaneously, the top ring air cylinder 111 connected to the top ring drive shaft 11 is actuated to press the retainer ring 3 fixed to the lower end of the top ring 1 against the polishing surface on the polishing table 100 under a predetermined pressure. In such a state, pressurized fluids are respectively supplied to the pressure chambers 222, 223, the central pressure chamber 224, and the intermediate pressure chamber 225 under respective pressures, thereby pressing the semiconductor wafer W against the polishing surface on the polishing table 100. The polishing liquid supply nozzle 102 supplies apolishing liquidQ onto the polishing pad 101 in advance, so that the polishing liquid Q is held on the polishing pad 101. Thus, the semiconductor wafer W is polished by the polishing pad 101 with the polishing liquid Q being present between the (lower) surface, to be polished, of the semiconductor wafer W and the polishing pad 101.

The local areas of the semiconductor wafer W that are positioned beneath the pressure chambers 222, 223 are pressed against the polishing surface under the pressures of the pressurized fluids supplied to the pressure chambers 222, 223. The local area of the semiconductor wafer W that is positioned beneath the central pressure chamber 224 is pressed via the elastic membrane 281 of the central bag 208 against the polishing surface under the pressure of the pressurized fluid supplied to the central pressure chamber 224. The local area of the semiconductor wafer W that is positioned beneath the intermediate pressure chamber 225 is pressed via the elastic membrane 291 of the ring tube 209 against the polishing surface under the pressure of the pressurized fluid supplied to the intermediate pressure chamber 225.

Therefore, the polishing pressures acting on the respective local areas of the semiconductor wafer W can be adjusted independently by controlling the pressures of the pressurized fluids supplied to the respective pressure chambers 222 to 225. Specifically, the respective regulators R3 to R6 independently regulate the pressures of the pressurized fluids supplied to the pressure chambers 222 to 225 for thereby adjusting the pressing forces applied to press the local areas of the semiconductor wafer W against the polishing pad 101 on the polishing table 100. With the polishing pressures on the respective local areas of the semiconductor wafer W being adjusted independently to desired values, the semiconductor wafer W is pressed against the polishing pad 101 on the polishing table 100 that is being rotated. Similarly, the pressure of the pressurized fluid supplied to the top ring air cylinder 111 can be regulated by the regulator R1 to adjust the force with which the retainer ring 3 presses the polishing pad 101. While the semiconductor wafer W is being polished, the force with which the retainer ring 3 presses the polishing pad 101 and the pressing force with which the semiconductor wafer W is pressed against the polishing pad 101 can appropriately be adjusted for thereby applying polishing pressures in a desired pressure distribution to a central area (C1 in FIG. 3), an inner area (C2) between the central area and an intermediate area, the intermediate area (C3), a peripheral area (C4) of the semiconductor wafer W, and a peripheral portion of the retainer ring 3 which is positioned outside of the semiconductor wafer W.

In this manner, the semiconductor wafer W is divided into the four concentric circular and annular areas (C1 to C4) , which can respectively be pressed under independent pressing forces. A polishing rate depends on a pressing force applied to a semiconductor wafer W against a polishing surface. As described above, since the pressing forces applied to those areas can independently be controlled, the polishing rates of the four circular and annular areas (C1 to C4) of the semiconductor wafer W can independently be controlled. Consequently, even if the thickness of a thin film to be polished on the surface of the semiconductor wafer W suffers radial variations, the thin film on the surface of the semiconductor wafer W can be polished uniformly without being insufficiently or excessively polished over the entire surface of the semiconductor wafer. More specifically, even if the thickness of the thin film to be polished on the surface of the semiconductor wafer W differs depending on the radial position on the semiconductor wafer W, the pressure in a pressure chamber positioned over a thicker area of the thin film is made higher than the pressure in other pressure chambers, or the pressure in a pressure chamber positioned over a thinner area of the thin film is made lower than the pressure in other pressure chambers. In this manner, the pressing force applied to the thicker area of the thin film against the polishing surface is made higher than the pressing force applied to the thinner area of the thin film against the polishing surface, thereby selectively increasing the polishing rate of the thicker area of the thin film. Consequently, the entire surface of the semiconductor wafer W can be polished exactly to a desired level over the entire surface of the semiconductor wafer W irrespective of the film thickness distribution produced at the time the thin film is formed.

Any unwanted edge rounding on the circumferential edge of the semiconductor wafer W can be prevented by controlling the pressing force applied to the retainer ring 3. If the thin film to be polished on the circumferential edge of the semiconductor wafer W has large thickness variations, then the pressing force applied to the retainer ring 3 is intentionally increased or reduced to thus control the polishing rate of the circumferential edge of the semiconductor wafer W. When the pressurized fluids are supplied to the pressure chambers 222 to 225, the chucking plate 206 is subjected to upward forces. In the present embodiment, the pressurized fluid is supplied to the pressure chamber 221 via the fluid passage 31 to prevent the chucking plate 206 from being lifted under the forces due to the pressure chambers 222 to 225.

As described above, the pressing force applied by the top ring air cylinder 111 to press the retainer ring 3 against the polishing pad 101 and the pressing forces applied by the pressurized air supplied to the pressure chambers 222 to 225 to press the local areas of the semiconductor wafer W against the polishing pad 101 are appropriately adjusted to polish the semiconductor wafer W. When the polishing of the semiconductor wafer W is finished, the semiconductor wafer W is attracted to the lower ends of the inner suction portions 261 and the outer suction portions 262 under vacuum in the same manner as described above. At this time, the supply of the pressurized fluids into the pressure chambers 222 to 225 to press the semiconductor wafer W against the polishing surface is stopped, and the pressure chambers 222 to 225 are vented to the atmosphere. Accordingly, the lower ends of the inner suction portions 261 and the outer suction portions 262 are brought into contact with the semiconductor wafer W. The pressure chamber 221 is vented to the atmosphere or evacuated to develop a negative pressure therein. If the pressure chamber 221 is maintained at a high pressure, then the semiconductor wafer W is strongly pressed against the polishing surface only in areas brought into contact with the inner suction portions 261 and the outer suction portions 262. Therefore, it is necessary to decrease the pressure in the pressure chamber 221 immediately. Accordingly, a relief port 239 penetrating from the pressure chamber 221 through the top ring body 2 may be provided for decreasing the pressure in the pressure chamber 221 immediately, as shown in FIG. 2. In this case, when the pressure chamber 221 is pressurized, it is necessary to continuously supply the pressurized fluid into the pressure chamber 221 via the fluidpassage 31. The relief port 239 comprises a check valve for preventing an outside air from flowing into the pressure chamber 221 at the time when a negative pressure is developed in the pressure chamber 221.

After attraction of the semiconductor wafer W, the top ring 1 as a whole is moved to a position to which the semiconductor wafer W is to be transferred, and then a fluid (e.g., compressed air or a mixture of nitrogen and pure water) is ejected to the semiconductor wafer W via the communication holes 261a, 262a of the inner suction portions 261 and the outer suction portions 262 to release the semiconductor wafer W from the top ring 1.

The polishing liquid Q used to polish the semiconductor wafer W tends to flow through the small gap G between the outer circumferential surface of the seal ring 204 and the retainer ring 3. If the polishing liquid Q is firmly deposited in the gap G, then the holder ring 205, the chucking plate 206, and the seal ring 204 are prevented from smoothly moving vertically with respect to the top ring body 2 and the retainer ring 3. To avoid such a drawback, a cleaning liquid (pure water) is supplied through the fluid passage 32 to the cleaning liquid passage 251. Accordingly, the pure water is supplied via a plurality of communication holes 253 to a region above the gap G, thus cleaning the gap G to prevent the polishing liquid Q from being firmly deposited in the gap G. The pure water should preferably be supplied after the polished semiconductor wafer W is released and until a next semiconductor wafer to be polished is attracted to the top ring 1. It is also preferable to discharge all the supplied pure water out of the top ring 1 before the next semiconductor wafer is polished, andhence to provide the retainer ring 3 with a plurality of through-holes 3a shown in FIG. 2. Furthermore, if a pressure buildup is developed in a space 226 defined between the retainer ring 3, the holder ring 205, and the pressurizing sheet 207, then it acts to prevent the chucking plate 206 from being elevated in the top ring body 2. Therefore, in order to allow the chucking plate 206 to be elevated smoothly in the top ring body 2, the through-holes 3a should preferably be provided for equalizing the pressure in the space 226 with the atmospheric pressure.

As described above, according to a substrate holding apparatus of the first embodiment, the pressures in the pressure chambers 222, 223, the pressure chamber 224 in the central bag 208, and the pressure chamber 225 in the ring tube 209 are independently controlled to control the pressing forces acting on the semiconductor wafer W.

A first example of the ring tube 209 in the substrate holding apparatus according to the first embodiment of the present invention will be described in detail below. Although only the ring tube 209 will be described below, the following description can be applied to the central bag 208.

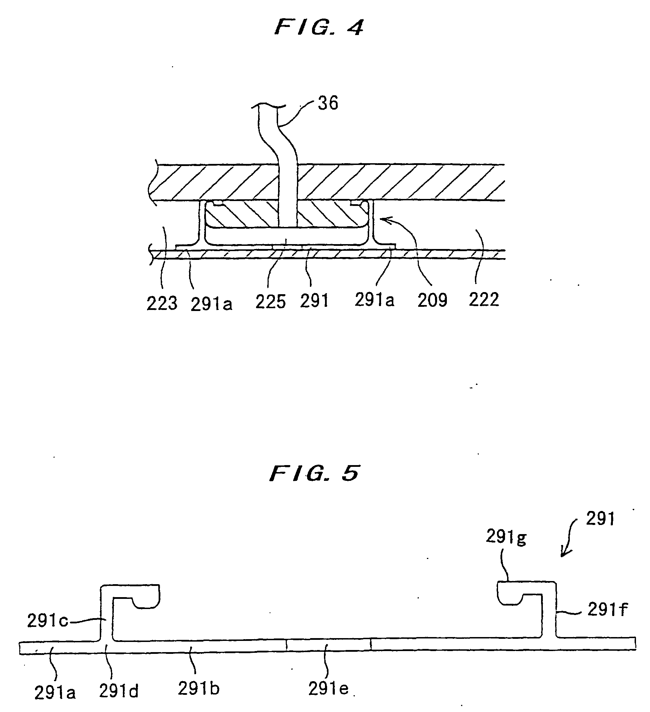

FIG. 4 is a vertical cross-sectional view showing the ring tube 209 shown in FIG. 2, and FIG. 5 is a vertical cross-sectional view showing the elastic membrane 291 of the ring tube 209 shown in FIG. 4. As shown in FIGS. 4 and 5, the elastic membrane 291 of the ring tube 209 in the first example has an abutment portion 291b having flanges 291a projecting outwardly, and connecting portions 291c connected via the ring tube holder 292 to the chucking plate 206. The connecting portions 291c extend upwardly from base portions 291d of the flanges 291a. A lower surface of the abutment portion 291b is brought into contact with the upper surface of the semiconductor wafer W. The flanges 291a, the abutment portion 291b, and the connecting portions 291c are integrally made of the same material.

As described above, when the semiconductor wafer is polished, pressurized fluids are supplied to the pressure chamber 222, and the pressure chamber 223 surrounding the ring tube 209. Thus, the flanges 291a are brought into close contact with the semiconductor wafer W by the pressurized fluids supplied to the pressure chambers 222, 223. Accordingly, even if the pressure of the pressurized fluid supplied to the pressure chamber 222 or 223 surrounding the pressure chamber 225 is considerably higher than the pressure of the pressurized fluid supplied to the pressure chamber 225 defined in the ring tube 209, the high-pressure fluid surrounding the pressure chamber 225 is prevented from flowing into the lower portion of the ring tube 209. Therefore, the flanges 291a can widen the range of pressure control in each of the pressure chambers, for thereby pressing the semiconductor wafer more stably.

Openings 291e are formed in central portions of the abutment portion 291b of the ring tube 209, and thus a pressurized fluid supplied to the intermediate pressure chamber 225 directly contacts with the upper surface of the semiconductor wafer W through the openings 291e of the abutment portion 291b. Since a pressurized fluid is supplied to the intermediate pressure chamber 225 during polishing, the pressurized fluid presses the abutment portion 291b of the ring tube 209 against the upper surface of the semiconductor wafer W. Therefore, even if the openings 291e are formed in the abutment portion 291b, a pressurized fluid in the intermediate pressure chamber 225 hardly flows out to the exterior of the intermediate pressure chamber 225. Further, when the semiconductor wafer W is released, a downward pressure can be applied through the openings 291e to the semiconductor wafer W by a pressurized fluid, so that the semiconductor wafer W can more smoothly be released.

When the pressurized fluid supplied to the intermediate pressure chamber 225 is controlled in temperature and the temperature of the semiconductor wafer W is controlled from the backside of the surface to be polished, as described above, the openings 291e formed in the abutment portion 291b of the ring tube 209 can increase the area in which the pressurized fluid controlled in temperature is brought into contact with the semiconductor wafer W. Therefore, controllability in temperature of the semiconductor wafer W can be improved. Further, when the polishing of the semiconductor wafer W is finished and the semiconductor wafer W is released, the intermediate pressure chamber 225 is opened to the outside air via the openings 291e. Thus, the fluid supplied into the intermediate pressure chamber 225 is prevented from remaining in the intermediate pressure chamber 225. Therefore, even if semiconductor wafers W are continuously polished, controllability in temperature of the semiconductor wafer W can be maintained.

In a case where the aforementioned flanges 291a are provided at the abutment portion 291b of the ring tube 209, when a pressurized fluid is supplied to the pressure chamber 221 to press the chucking plate 206 downwardly for polishing, downward forces may excessively be applied to portions of the semiconductor wafer W near the base portions 291d of the flanges 291a of the ring tube 209 by the connecting portions 291c, so that a polishing rate may be locally increased at those portions.

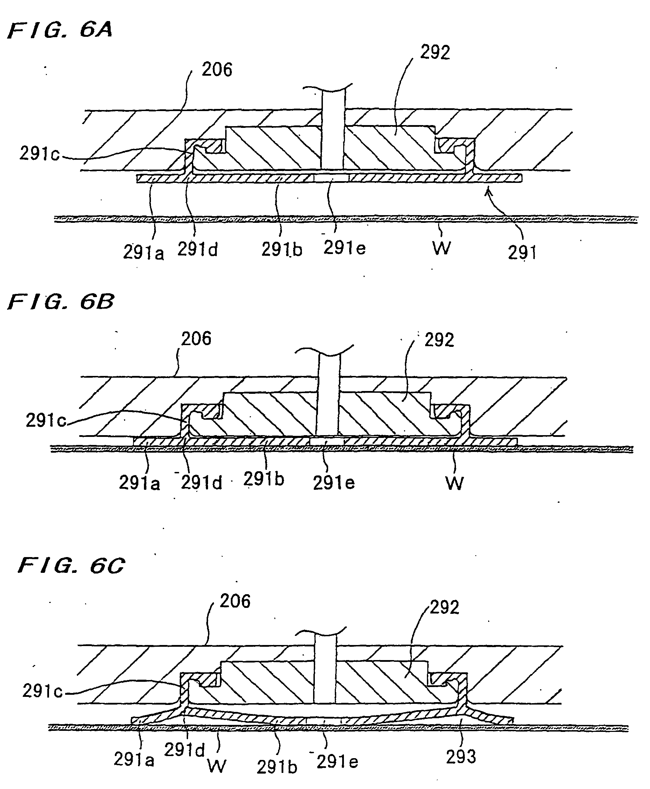

On the other hand, as shown in FIGS. 6A through 6C, in a case where, after the semiconductor wafer W is brought into close contact with the abutment portion 291b of the ring tube 209, the pressure chamber 221 is supplied with a pressure smaller than the sum of pressing forces applied to the pressure chambers 222 to 225 to polish the semiconductor wafer in such a state that the chucking plate 206 is lifted, upward forces may be applied to portions near the base portions 291d of the flanges 291a which is brought into close contact with the semiconductor wafer W by the connecting portions 291c. Thus, a vacuum 293 may be formed near the base portions 291d (see FIG. 6C), so that a polishing rate may be locally lowered at those portions.

In the above viewpoints, in the present embodiment, the connecting portions 291c of the ring tube 209 are made of a soft material having a higher flexibility than the abutment portion 291b. With this configuration, even if the chucking plate 206 is downwardly pressed for polishing, excessive downward forces are not applied to the semiconductor wafer W which is brought into close contact with the abutment portion 291b because the connecting portions 291c are likely to be elastically deformed, so that a uniform polishing rate can be achieved over the entire surface of the abutment portion 291b except the flanges 291a. Further, even if the chucking plate 206 is lifted for polishing, excessive upward forces are not applied to the abutment portion 291b because the connecting portions 291c are likely to extend. Thus, a vacuum is not formed near the base portions 291d of the flanges 291a, so that a uniform polishing rate can be achieved over the entire surface of the abutment portion 291b except the flanges 291a. Only a vertically extending portions 291f (see FIG. 5) of the connecting portions 291c may be made of a soft material having a high flexibility, or, in addition thereto, portions 291g held by the ring tube holder 292 may also be made of a soft material having a high flexibility.

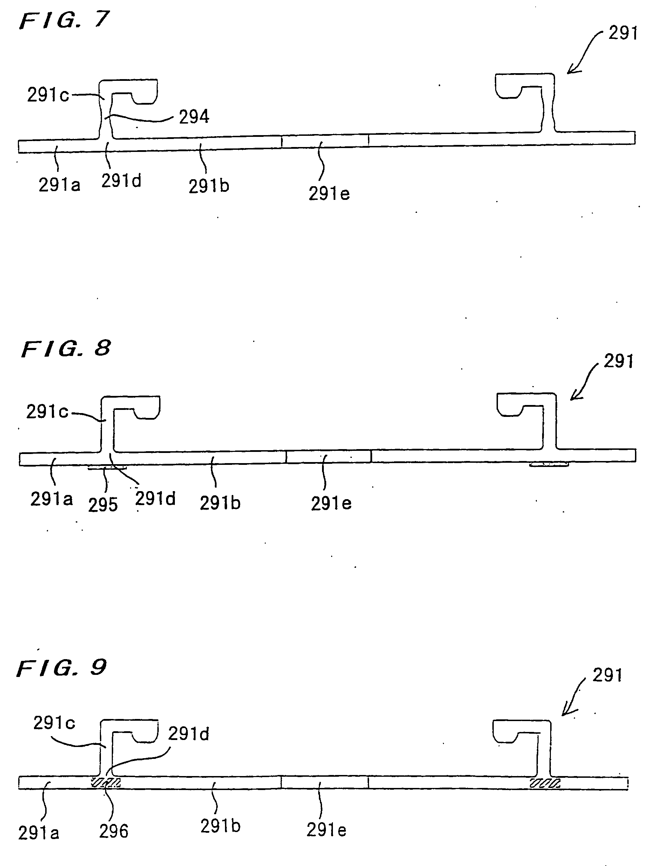

FIG. 7 is a vertical cross-sectional view showing a second example of an elastic membrane of a ring tube in a substrate holding apparatus according to the present invention. In the ring tube of the second example, the connecting portions 291c have thin portions 294 having a thickness smaller than the thickness of the abutment portion 291b. The thin portions 294 are constricted inwardly as shown in FIG. 7. With such thin portions 294, even if the chucking plate 206 is pressed downwardly for polishing, excessive downward forces are not applied to the semiconductor wafer W which is brought into close contact with the abutment portion 291b because the connecting portions 291c are likely to be deformed at the thin portions 294, so that a uniform polishing rate canbe achieved over the entire surface of the abutment portion 291b except the flanges 291a. Further, even if the chucking plate 206 is lifted for polishing, excessive upward forces are not applied to the abutment portion 291b because the thin portions 294 are likely to extend. Thus, a vacuum is not formed near the base portions 291d of the flanges 291a, so that a uniform polishing rate can be achieved over the entire surface of the abutment portion 291b except the flanges 291a. Particularly, when the thin portions 294 are formed so as to be constricted inwardly in a cross-section, the above effects can effectively be achieved.

FIG. 8 is a vertical cross-sectional view showing a third example of an elastic membrane of a ring tube in a substrate holding apparatus according to the present invention. In the ring tube of the third example, intermediate members 295 having a low adhesiveness to the semiconductor wafer W is attached to the lower surfaces of the baseportions 291d of the flanges 291a. Anymembers can be used as the intermediate member 295 as long as it has a low adhesiveness to the wafer W. For example, a cellophane tape may be used as the intermediate member 295. The intermediate member 295 should preferably be as thin as possible, and preferably have a thickness of 0.2 mm or smaller. With this arrangement, even if the chucking plate 206 is lifted for polishing, a vacuum is unlikely to be formed near the base portions 291d of the flanges 291abecause the base portions 291d of the flanges 291a are unlikely to be brought into close contact with the semiconductor wafer W. Therefore, a uniform polishing rate can be achieved over the entire surface of the abutment portion 291b except the flanges 291a. Instead of mounting such intermediate members 295, adhesiveness between the base portions 291d of the flanges 291a and the semiconductor wafer W may be weakened, for example, by forming a groove in the lower surfaces of the base portions 291d of the flanges 291a, or by forming the lower surfaces of the base portions 291d as rough surfaces.

FIG. 9 is a vertical cross-sectional view showing a fourth example of an elastic membrane of a ring tube in a substrate holding apparatus according to the present invention. In the ring tube of the fourth example, ring-like hardmembers 296made of amaterial harder than the elastic membrane 291 (e.g., stainless) are embedded in the base portions 291d of the flanges 291a. With this arrangement, even if the chucking plate 206 is downwardly pressed for polishing, excessive downward forces are not applied to the semiconductor wafer W which is brought into close contact with the abutment portion 291b because downward forces by the connecting portions 291c are dispersed by the hard members 296, so that a uniform polishing rate can be achieved over the entire surface of the abutment portion 291b except the flanges 291a. Further, even if the chucking plate 206 is lifted for polishing, a vacuum is not formed near the base portions 291d of the flanges 291a because the hard members 296 prevent deformation of the vicinity of the base portions 291d of the flanges 291a. Therefore, a uniform polishing rate can be achieved over the entire surface of the abutment portion 291b except the flanges 291a.

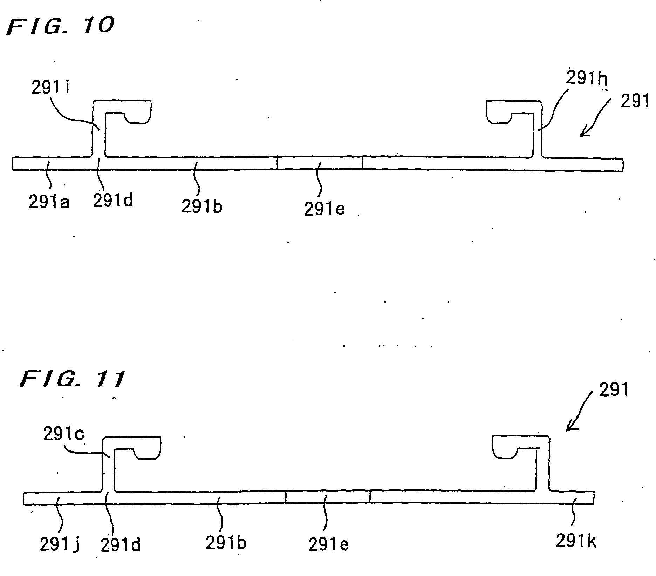

FIG. 10 is a vertical cross-sectional view showing a fifth example of an elastic membrane of a ring tube in a substrate holding apparatus according to the present invention. The fifth example corresponds to an example of a ring tube in which a connecting portion 291h positioned radially inwardly, i.e., near the center of the semiconductor wafer W, has a thickness smaller than a connecting portion 291i positioned radially outwardly, in the elasticmembrane 291 of the ring tube of the first example. Because a cylinder having a smaller curvature generally has a stiffness larger than a cylinder having a larger curvature, a vertical force applied to the base portion of the flange by the connecting portion positioned radially inwardly becomes larger than a force applied to the base portion of the flange by the connecting portion positioned radially outwardly. Therefore, as shown in the fifth example, when the connecting portion 291h positioned radially inwardly is thinner than the connecting portion 291i positioned radially outwardly, vertical forces applied to the base portions of the flanges by these connecting portions 291h, 291i can be adjusted to the same level, and a uniform polishing rate can be achieved over the entire surface of the abutment portion 291b except the flanges 291a. When the connecting portion positioned radially inwardly is made of amaterial having a flexibility higher than the connecting portion positioned radially outwardly in the ring tube of the first example, the similar effects are expected.

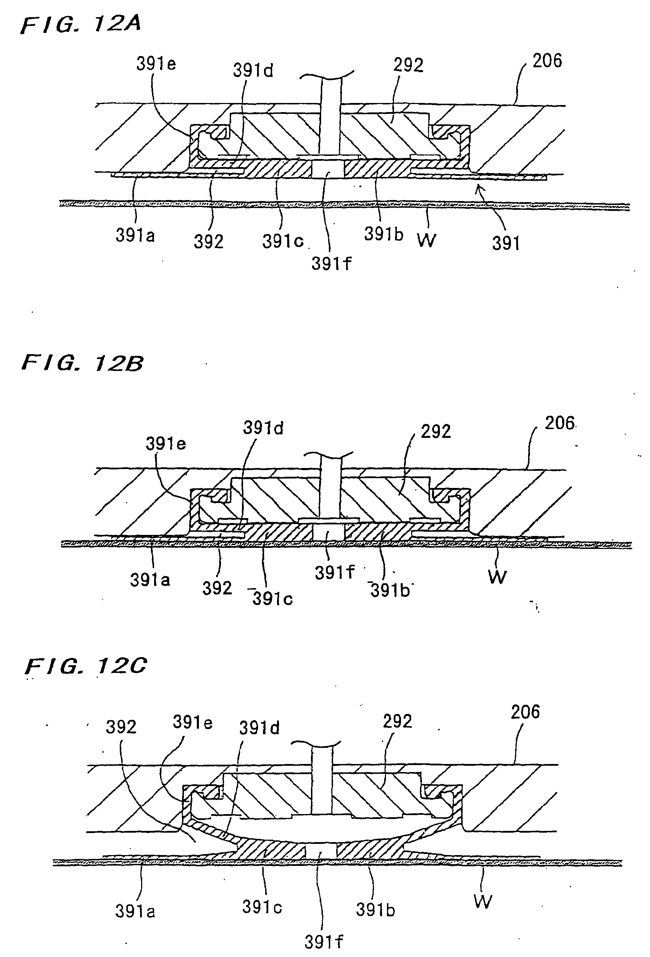

FIG. 11 is a vertical cross-sectional view showing a sixth example of an elasticmembrane of a ring tube in a substrate holding apparatus according to the present invention. The sixth example corresponds to an example of a ring tube in which a flange 291j projecting radially outwardly has a length larger than a flange 291k projecting radially inwardly, in the elastic membrane 291 of the ring tube of the first example. With this arrangement, a sealing capability can be enhanced at the flange 291j projecting radially outwardly, so that a uniform polishing rate can be achieved over the entire surface of the abutment portion 291b except the flanges 291a.

FIGS. 12A through 12C are vertical cross-sectional views showing a seventh example of a ring tube in a substrate holding apparatus according to the present invention. As shown in FIG. 12A, the elastic membrane 391 of the ring tube of the seventh example has an abutment portion 391b having flanges 391a projecting outwardly, extending portions 391d extending outwardly from base portions 391c of the flanges 391a to form grooves 392 between the extending portions 391d and the flanges 391a, and connecting portions 391e connected via the ring tube holder 292 to the chucking plate 206. The extending portions 391d extend outwardly from the base portions 391c of the flanges 391a to positions inward of tips of the flanges 391a, and the connecting portions 391e extend upwardly from outward ends of the extending portions 391d. The flanges 391a, the abutment portion 391b, the connecting portions 391e, and the extending portions 391d are integrallymade of the same material. Anopening 391f is formed in a central portion of the abutment portion 391b.

With this arrangement, in a case where the chucking plate 206 is lifted for polishing after the semiconductor wafer W is brought into close contact with the abutment portion 391b (see FIG. 12B), upward forces by the connecting portions 391e are converted into forces in horizontal or oblique directions by the extending portions 391d, and the converted forces are applied to the base portions 391c of the flanges 391a (see FIG. 12C). Therefore, upward forces applied to the base portions 391c of the flanges 391a can be made extremely small, so that excessive upward forces are not applied to the abutment portion 391b. Accordingly, a vacuum is not formed near the base portions 391d, so that a uniform polishing rate can be achieved over the entire surface of the abutment portion 391b except the flanges 391a. In this case, the thickness of the connecting portions 391e or the length of the flanges 391a may be varied between the connecting portion disposed radially inwardly and the connecting portion disposed radially outwardy, as with the ring tube in the fifth or sixth example. Further, the length of the extending portions 391dmaybe variedbetween the extending portion disposed radially inwardly and the extending portion disposed radially outwardly. Furthermore, the thickness of the flanges 391a may be varied according to the type of a film formed on the semiconductor wafer to be polished or the polishing pad. When the resistance or the polishing torque transmitted to the semiconductor wafer is large, the thickness of the flanges 391a should preferably be made larger in order to prevent torsion of the flanges 391a.

In the substrate holding apparatus according to the first embodiment described above, the fluid passages 31, 33, 34, 35 and 36 are provided as separate passages. However, these fluid passages may be combined with each other, or the pressure chambers may be communicated with each other in accordance with the magnitude of the pressing force to be applied to the semiconductor wafer W and the position to which the pressing force is applied. In the first embodiment, the central bag 208 and the ring tube 209 are brought into direct contact with the semiconductor wafer W. However, the present invention is not limited to such a configuration. For example, an elastic pad may be interposed between the central bag 208 and ring tube 209 and the semiconductor wafer W so that the central bag 208 and the ring tube 209 are brought into indirect contact with the semiconductor wafer W. Further, the above examples may appropriately be combined with each other.

In the substrate holding apparatus according to the first embodiment described above, the polishing surface is constituted by the polishing pad. However, the polishing surface is not limited to this. For example, the polishing surface may be constituted by a fixed abrasive. The fixed abrasive is formed into a flat plate comprising abrasive particles fixed by a binder. With the fixed abrasive for polishing, the polishing process is performed by the abrasive particles self-generated from the fixed abrasive. The fixed abrasive comprises abrasive particles, a binder, and pores. For example, cerium dioxide (CeO2) having an average particle diameter of 0.5 µm is used as an abrasive particle, and epoxy resin is used as a binder. Such a fixed abrasive forms a harder polishing surface. The fixed abrasive includes a fixed abrasive pad having a two-layer structure formed by a thin layer of a fixed abrasive and an elastic polishing pad attached to a lower surface of the layer of the fixed abrasive. IC-1000 described above may be used for another hard polishing surface.

As described above, according to the substrate holding apparatus of the first embodiment of the present invention, pressures to be applied to the substrate can independently be controlled, and hence a pressing force applied to a thicker area of a thin film can be made higher than a pressing force applied to a thinner area of the thin film, thereby selectively increasing the polishing rate of the thicker area of the thin film. Thus, an entire surface of a substrate can be polished exactly to a desired level irrespective of the film thickness distribution obtained at the time the thin film is formed. Further, even if a vertically movable member is pressed downwardly for polishing, excessive downward forces are not applied to the substrate which is brought into close contact with the abutment portion, so that a uniform polishing rate can be achieved in an area between the base portions. Further, even if a vertically movable member is lifted for polishing, excessive upward forces are not applied to the abutment portion, so that a vacuum is not formed near the base portions of the flanges to achieve a uniform polishing rate in an area between the base portions.

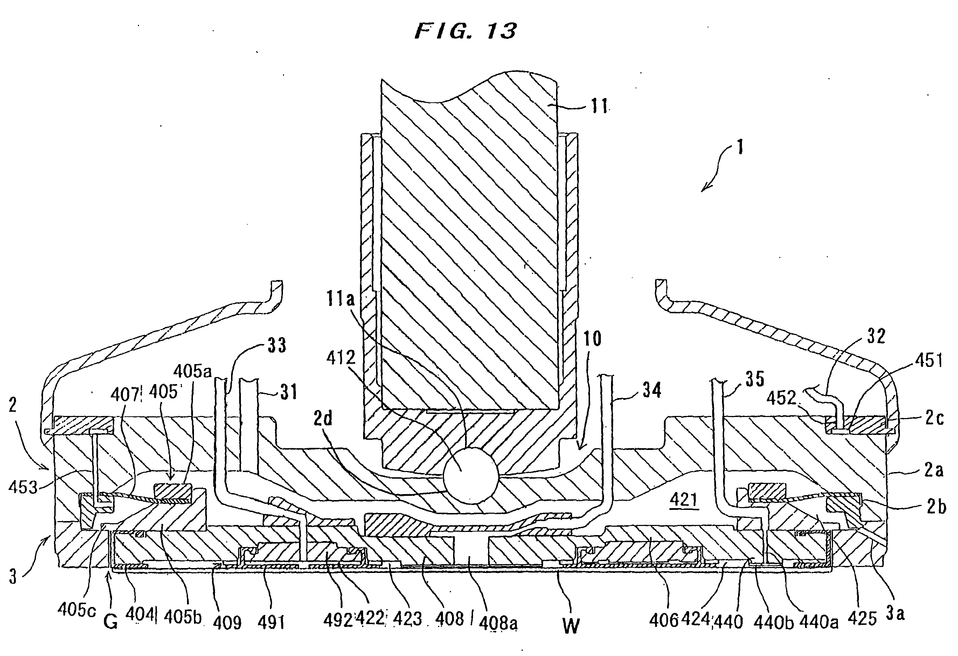

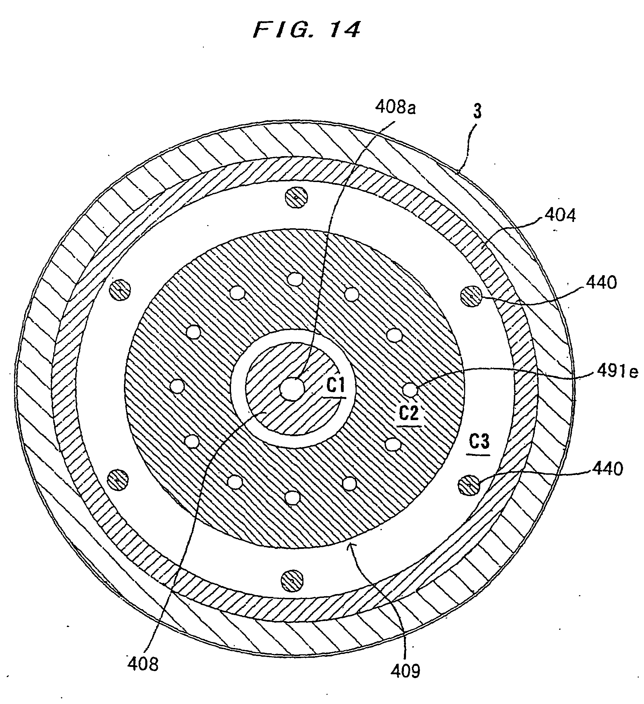

Next, a substrate holding apparatus according to a second embodiment of the present invention will be described below. FIG. 13 is a vertical cross-sectional view showing a top ring 1 as a substrate holding apparatus according to the second embodiment of the present invention, and FIG. 14 is a bottom view showing the top ring 1 shown in FIG. 13. As shown in FIG. 13, the top ring 1 constituting a substrate holding apparatus comprises a top ring body 2 in the formof a cylindrical housingwith a receiving space defined therein, and a retainer ring 3 fixed to the lower end of the top ring body 2. The top ring body 2 is made of a material having high strength and rigidity, such as metal or ceramics. The retainer ring 3 is made of highly rigid synthetic resin, ceramics, or the like.

The top ring body 2 comprises a cylindrical housing 2a, an annular pressurizing sheet support 2b fitted into the cylindrical portion of the housing 2a, and an annular seal 2c fitted over an outer circumferential edge of an upper surface of the housing 2a. The retainer ring 3 is fixed to the lower end of the housing 2a of the top ring body 2. The retainer ring 3 has a lower portion proj ecting radially inwardly. The retainer ring 3 may be formed integrally with the top ring body 2.

A top ring drive shaft 11 is disposed above the central portion of the housing 2a of the top ring body 2, and the top ring body 2 is coupled to the top ring drive shaft 11 by a universal joint 10. The universal joint 10 has a spherical bearingmechanism by which the top ring body 2 and the top ring drive shaft 11 are tiltable with respect to each other, and a rotation transmitting mechanism for transmitting the rotation of the top ring drive shaft 11 to the top ring body 2. The spherical bearing mechanism and the rotation transmitting mechanism transmit a pressing force and a rotating force from the top ring drive shaft 11 to the top ring body 2 while allowing the top ring body 2 and the top ring drive shaft 11 to be tilted with respect to each other.

The spherical bearing mechanism comprises a hemispherical concave recess 11a defined centrally in the lower surface of the top ring drive shaft 11, a hemispherical concave recess 2d defined centrally in the upper surface of the housing 2a, and a bearing ball 12 made of a highly hard material such as ceramics and interposed between the concave recesses 11a and 2d. On the other hand, the rotation transmitting mechanism comprises drive pins (not shown) fixed to the top ring drive shaft 11, and driven pins (not shown) fixed to the housing 2a. Even if the top ring body 2 is tilted with respect to the top ring drive shaft 11, the drive pins and the driven pins remain in engagement with each other while contact points are displaced because the drive pin and the driven pin are vertically movable relatively to each other. Thus, the rotation transmitting mechanism reliably transmits rotational torque of the top ring drive shaft 11 to the top ring body 2.

The top ring body 2 and the retainer ring 3 secured to the top ring body 2 have a space defined therein, which accommodates therein a seal ring 404 having a lower surface brought into contact with a peripheral portion of the semiconductor wafer W held by the top ring 1, an annular holder ring 405, and a disk-shaped chuckingplate406 (verticallymovablemember) which is vertically movable within the receiving space in the top ring body 2.

The seal ring 404 has a radially outer edge clamped between the holder ring 405 and the chucking plate 406 secured to the lower end of the holder ring 405 and extends radially inwardly so as to cover the lower surface of the chucking plate 406 near its outer circumferential edge. The lower end surface of the seal ring 404 is brought into contact with the upper surface of the semiconductor wafer W to be polished. The seal ring 404 is made of a highly strong and durable rubber material such as ethylene propylene rubber (EPDM), polyurethane rubber, or silicone rubber. The semiconductor wafer W has a recess defined in an outer edge thereof, which is referred to as a notch or orientation flat, for recognizing (identifying) the orientation of the semiconductor wafer. The seal ring 404 should preferably extend radially inwardly of the chucking plate 406 from the innermost position of such as a notch or orientation flat.

A pressurizing sheet 407 comprising an elastic membrane extends between the holder ring 405 and the top ring body 2. The pressurizing sheet 407 has a radially outer edge clamped between the housing 2a and the pressurizing sheet support 2b of the top ring body 2, and a radially inner edge clamped between an upper end portion 405a and a stopper 405b of the holder ring 405. The top ring body 2, the chucking plate 406, the holder ring 405, and the pressurizing sheet 407 jointly define a pressure chamber 421 in the top ring body 2. As shown in FIG. 13, a fluid passage 31 comprising tubes and connectors communicates with the pressure chamber 421, which is connected to a compressed air source 120 via a regulator R2 provided on the fluid passage 31. The pressurizing sheet 407 is made of a highly strong and durable rubber material such as ethylene propylene rubber (EPDM), polyurethane rubber, or silicone rubber.

In the case where the pressurizing sheet 407 is made of an elastic material such as rubber, if the pressurizing sheet 407 is fixedly clamped between the retainer ring 3 and the top ring body 2, then a desired horizontal surface cannot be maintained on the lower surface of the retainer ring 3 because of elastic deformation of the pressurizing sheet 407 as an elastic material. In order to prevent such a drawback, the pressurizing sheet 407 is clamped between the housing 2a of the top ring body 2 and the pressurizing sheet support 2b provided as a separate member in the present embodiment. The retainer ring 3 may vertically be movable with respect to the top ring body 2, or the retainer ring 3 may have a structure capable of pressing the polishing surface independently of the top ring body 2. In such cases, the pressurizing sheet 407 is not necessarily fixed in the aforementioned manner.

A cleaning liquid passage 451 in the form of an annular groove is defined in the upper surface of the housing 2a near its outer circumferential edge over which the seal 2c of the top ring body 2 is fitted. The cleaning liquid passage 451 communicates with a fluid passage 32 via a through-hole 452, and is supplied with a cleaning liquid (pure water) via the fluid passage 32. A plurality of communication holes 453 are defined in the housing 2a and the pressurizing sheet support 2b in communication with the cleaning liquid passage 451. The communication holes 453 communicate with a small gap G defined between the outer circumferential surface of the seal ring 404 and the inner circumferential surface of the retainer ring 3.

The chucking plate 406 has a central port 408 provided on a lower surface of a central portion of the chucking plate 406, with an opening 408a defined at a central portion of the central port 408. A ring tube 409 which serves as an abutment member brought into contact with the semiconductor wafer W is mounted in a space defined between the chucking plate 406 and the semiconductor wafer W. In the present embodiment, as shown in FIGS. 13 and 14, the ring tube 409 is disposed radially outwardly of the central port 408 in surrounding relation thereto. The chucking plate 406 has suction portions 440 extended downwardly therefrom outside of the ring tube 409. In the present embodiment, six suction portions 440 are provided.

The ring tube 409 comprises an elastic membrane 491 brought into contact with the upper surface of the semiconductor wafer W, and a ring tube holder 492 for detachably holding the elastic membrane 491 in position. The ring tube 409 has a pressure chamber 422 defined therein by the elastic membrane 491 and the ring tube holder 492. The space defined between the chucking plate 406 and the semiconductor wafer W is divided into a plurality of spaces by the ring tube 409. Accordingly, a pressure chamber 423 is defined radially inwardly of the ring tube 409, i.e., around the central port 408, and a pressure chamber 424 is defined radially outwardly of the ring tube 409, i.e., around the suction portions 440. The elastic membrane 491 of the ring tube 409 is made of a highly strong and durable rubber material such as ethylene propylene rubber (EPDM), polyurethane rubber, or silicone rubber, as with the pressurizing sheet 407.

A fluid passage 33 comprising tubes and connectors communicates with the pressure chamber 422 in the ring tube 409. The pressure chamber 422 is connected to the compressed air source 120 via a regulator R3 connected to the fluid passages 33. A fluid passage 34 comprising tubes and connectors communicates with the opening 408a of the central port 408. The central port 408 is connected to the compressed air source 120 via a regulator R4 connected to the fluid passages 34. The suction portion 440 has a communication hole 440a communicating with a fluid passage 35 comprising tubes and connectors. The suction portions 440 are connected to the compressed air source 120 via a regulator R5 connected to the fluid passages 35. The compressed air source 120 develops a negative pressure at the opening ends of the communication holes 440a of the suction portions 440 to attract a semiconductor wafer W to the suction portions 440. The suction portions 440 have elastic sheets 440b, such as thin rubber sheets, attached to their lower ends, for thereby elastically contacting and holding the semiconductor wafer W on the lower surfaces thereof. The pressure chambers 421 to 424 are connected to the respective regulators R2 to R5 through a rotary joint (not shown) mounted on the upper end of the top ring shaft 110.

The pressure chamber 421 above the chucking plate 406 and the pressure chambers 422, 423, 424 are supplied with pressurized fluids such as pressurized air or atmospheric air or evacuated, via the fluidpassages 31, 33, 34 and 35 connected to the respective pressure chambers. As shown in FIG. 1, the regulators R2 to R5 connected to the fluid passages 31, 33, 34 and 35 of the pressure chambers 421 to 424 can respectively regulate the pressures of the pressurized fluids supplied to the respective pressure chambers. Thus, it is possible to independently control the pressures in the pressure chambers 421 to 424 or independently introduce atmospheric air or vacuum into the pressure chambers 421 to 424. In this manner, the pressures in the pressure chambers 421 to 424 are independently varied with the regulators R2 to R5, so that the pressing forces to press the semiconductor wafer W against the polishing pad 101 can be adjusted in local areas of the semiconductor wafer W.

In this case, the pressurized fluid or the atmospheric air supplied to the pressure chambers 422 to 424 may independently be controlled in temperature. With this configuration, it is possible to directly control the temperature of a workpiece such as a semiconductor wafer from the backside of the surface to be polished. Particularly, when each of the pressure chambers is independently controlled in temperature, the rate of chemical reaction can be controlled in the chemical polishing process of CMP.

Since there is a small gap G between the outer circumferential surface of the seal ring 404 and the inner circumferential surface of the retainer ring 3, the holder ring 405, the chucking plate 406, and the seal ring 404 attached to the chucking plate 406 can vertically be moved with respect to the top ring body 2 and the retainer ring 3, and hence are of a floating structure with respect to the top ring body 2 and the retainer ring 3. The stopper 405b of the holder ring 405 has a plurality of teeth 405c projecting radially outwardly from the outer circumferential edge thereof. Downward movement of the members including the holder ring 405 is limited to a predetermined range by engaging the teeth 405c with the upper surface of the radially inwardly projecting portion of the retainer ring 3.

For example, in a case where the chucking plate is made of PPS (polyphenylene sulfide), if the pressure in the pressure chamber 421 is higher than the pressures in the pressure chambers 422 to 424 below the chucking plate 406, the chucking plate is bent so that the suction portions 440 press the semiconductor wafer W to increase polishing rates at those local areas. Accordingly, the chucking plate 406 in the present embodiment is made of a material having a larger stiffness and a lighter weight than PPS, e.g., epoxy resin, preferably a fiber reinforced material such as a glass fiber reinforced material. Thus, with the chucking plate 406 made of a material having a large stiffness, even if the pressure in the pressure chamber 421 is higher than the pressures in the pressure chambers 422 to 424 below the chucking plate 406, the chucking plate 406 becomes unlikely to be bent, so that polishing rates are prevented frombeing locally increased. Particularly, since epoxy resin has no magnetism, it is suitable for cases where the film thickness of a thin film formed on a surface of a semiconductor wafer is measured with a film thickness method using eddy current in such a state that the semiconductor wafer to be polished is held by a top ring. The material is not limited to epoxy resin, and it is also effective to use other resin having a large stiffness, fiber reinforced materials thereof, or ceramics.

Next, operation of the top ring 1 thus constructed will be described in detail below.

In the polishing apparatus constructed above, when a semiconductor wafer W is to be delivered to the polishing apparatus, the top ring 1 as a whole is moved to a position to which the semiconductor wafer W is transferred, and the communication holes 440a of the suction portions 440 are connected via the fluidpassage 35 to the vacuum source 121. The semiconductor wafer W is attracted under vacuum to the lower ends of the suction portions 440 by suction effect of the communication holes 440a. With the semiconductor wafer W attracted to the top ring 1, the top ring 1 as a whole is moved to a position above the polishing table 100 having the polishing surface (polishing pad 101) thereon. The outer circumferential edge of the semiconductor wafer W is held by the retainer ring 3 so that the semiconductor wafer W is not removed from the top ring 1.

For polishing the semiconductor wafer W, the attraction of semiconductor wafer W by the suction portions 440 is released, and the semiconductor wafer W is held on the lower surface of the top ring 1. Simultaneously, the top ring air cylinder 111 connected to the top ring drive shaft 11 is actuated to press the retainer ring 3 fixed to the lower end of the top ring 1 against the polishing surface on the polishing table 100 under a predetermined pressure. In such a state, pressurized fluids are respectively supplied to the pressure chamber 422, 423, 424 under respective pressures, thereby pressing the semiconductor wafer W against the polishing surface on the polishing table 100. The polishing liquid supply nozzle 102 supplies a polishing liquid Q onto the polishing pad 101 in advance, so that the polishing liquid Q is held on the polishing pad 101. Thus, the semiconductor wafer W is polished by the polishing pad 101 with the polishing liquid Q being present between the (lower) surface, to be polished, of the semiconductor wafer W and the polishing pad 101.

The local areas of the semiconductor wafer W that are positioned beneath the pressure chambers 423, 424 are pressed against the polishing surface under the pressures of the pressurized fluids supplied to the pressure chambers 423, 424. The local area of the semiconductor wafer W that is positioned beneath the central pressure chamber 422 is pressed via the elastic membrane 491 of the ring tube 409 against the polishing surface under the pressure of the pressurized fluid supplied to the pressure chamber 422. Therefore, the polishing pressures acting on the respective local areas of the semiconductor wafer W can be adjusted independently by controlling the pressures of the pressurized fluids supplied to the respective pressure chambers 422 to 424. Specifically, the respective regulators R3 to R5 independently regulate the pressures of the pressurized fluids supplied to the pressure chambers 422 to 424 for thereby adjusting the pressing forces applied to press the local areas of the semiconductor wafer W against the polishing pad 101 on the polishing table 100. With the polishing pressures on the respective local areas of the semiconductor wafer W being adj usted independently to desired values, the semiconductor wafer W is pressed against the polishing pad 101 on the polishing table 100 that is being rotated. Similarly, the pressure of the pressurized fluid supplied to the top ring air cylinder 111 can be regulated by the regulator R1 to adjust the force with which the retainer ring 3 presses the polishing pad 101. While the semiconductor wafer W is being polished, the force with which the retainer ring 3 presses the polishing pad 101 and the pressing force with which the semiconductor wafer W is pressed against the polishing pad 101 can appropriately be adjusted for thereby applying polishing pressures in a desired pressure distribution to a central area (C1 in FIG. 14), an intermediate area (C2), a peripheral area (C3), and a peripheral portion of the retainer ring 3 which is positioned outside of the semiconductor wafer W.

In this manner, the semiconductor wafer W is divided into the three concentric circular and annular areas (C1 to C3), which can respectively be pressed under independent pressing forces. A polishing rate depends on a pressing force applied to a semiconductor wafer W against a polishing surface. As described above, since the pressing forces applied to those areas can independently be controlled, the polishing rates of the three circular and annular areas (C1 to C3) of the semiconductor wafer W can independently be controlled. Consequently, even if the thickness of a thin film to be polished on the surface of the semiconductor wafer W suffers radial variations, the thin film on the surface of the semiconductor wafer W can be polished uniformly without being insufficiently or excessively polished over the entire surface of the semiconductor wafer. More specifically, even if the thickness of the thin film to be polished on the surface of the semiconductor wafer W differs depending on the radial position on the semiconductor wafer W, the pressure in a pressure chamber positioned over a thicker area of the thin film is made higher than the pressure in other pressure chambers, or the pressure in a pressure chamber positioned over a thinner area of the thin film is made lower than the pressure in other pressure chambers. In this manner, the pressing force applied to the thicker area of the thin film against the polishing surface is made higher than the pressing force applied to the thinner area of the thin film against the polishing surface, thereby selectively increasing the polishing rate of the thicker area of the thin film. Consequently, the entire surface of the semiconductor wafer W can be polished exactly to a desired level over the entire surface of the semiconductor wafer W irrespective of the film thickness distribution produced at the time the thin film is formed.

Any unwanted edge rounding on the circumferential edge of the semiconductor wafer W can be prevented by controlling the pressing force applied to the retainer ring 3. If the thin film to be polished on the circumferential edge of the semiconductor wafer W has large thickness variations, then the pressing force applied to the retainer ring 3 is intentionally increased or reduced to thus control the polishing rate of the circumferential edge of the semiconductor wafer W. When the pressurized fluids are supplied to the pressure chambers 422 to 424, the chucking plate 406 is subjected to upward forces. In the present embodiment, the pressurized fluid is supplied to the pressure chamber 421 via the fluid passage 31 to prevent the chucking plate 406 from being lifted under the forces due to the pressure chambers 422 to 424.

As described above, the pressing force applied by the top ring air cylinder 111 to press the retainer ring 3 against the polishing pad 101 and the pressing forces applied by the pressurized air supplied to the pressure chambers 422 to 424 to press the local areas of the semiconductor wafer W against the polishing pad 101 are appropriately adjusted to polish the semiconductor wafer W. When the polishing of the semiconductor wafer W is finished, the semiconductor wafer W is attracted again to the lower ends of the suction portions 440 under vacuum. At this time, the supply of the pressurized fluids into the pressure chambers 422 to 424 to press the semiconductor wafer W against the polishing surface is stopped, and the pressure chambers 422 to 424 are vented to the atmosphere. Accordingly, the lower ends of the suction portions 440 are brought into contact with the semiconductor wafer W. The pressure chamber 421 is vented to the atmosphere or evacuated to develop a negative pressure therein. If the pressure chamber 421 is maintained at a high pressure, then the semiconductor wafer W is strongly pressed against the polishing surface only in areas brought into contact with the suction portions 440.

After attraction of the semiconductor wafer W, the top ring 1 as a whole is moved to a position to which the semiconductor wafer W is to be transferred, and then a fluid (e.g., compressed air or a mixture of nitrogen and pure water) is ejected to the semiconductor wafer W via the communication holes 440a of the suction portions 440 to release the semiconductor wafer W from the top ring 1.

The polishing liquid Q used to polish the semiconductor wafer W tends to flow through the small gap G between the outer circumferential surface of the seal ring 404 and the retainer ring 3. If the polishing liquid Q is firmly deposited in the gap G, then the holder ring 405, the chucking plate 406, and the seal ring 404 are prevented from smoothly moving vertically with respect to the top ring body 2 and the retainer ring 3. To avoid such a drawback, a cleaning liquid (pure water) is supplied through the fluid passage 32 to the cleaning liquid passage 451. Accordingly, the pure water is supplied via a plurality of communication holes 453 to a region above the gap G, thus cleaning the gap G to prevent the polishing liquid Q from being firmly deposited in the gap G. The pure water should preferably be supplied after the polished semiconductor wafer W is released and until a next semiconductor wafer to be polished is attracted to the top ring 1. It is also preferable to discharge all the supplied pure water out of the top ring 1 before the next semiconductor wafer is polished, and hence to provide the retainer ring 3 with a plurality of through-holes 3a shown in FIG. 13. Furthermore, if a pressure buildup is developed in a space 425 defined between the retainer ring 3, the holder ring 405, and the pressurizing sheet 407, then it acts to prevent the chucking plate 406 from being elevated in the top ring body 2. Therefore, in order to allow the chucking plate 406 to be elevated smoothly in the top ring body 2, the through-holes 3a should preferably be provided for equalizing the pressure in the space 425 with the atmospheric pressure.

As described above, according to a substrate holding apparatus of the second embodiment, the pressures in the pressure chambers 422, 423, 424 are independently controlled to control the pressing forces acting on the semiconductor wafer W.

The ring tube 409 of the substrate holding apparatus according to the second embodiment of the present invention will be described in detail below.

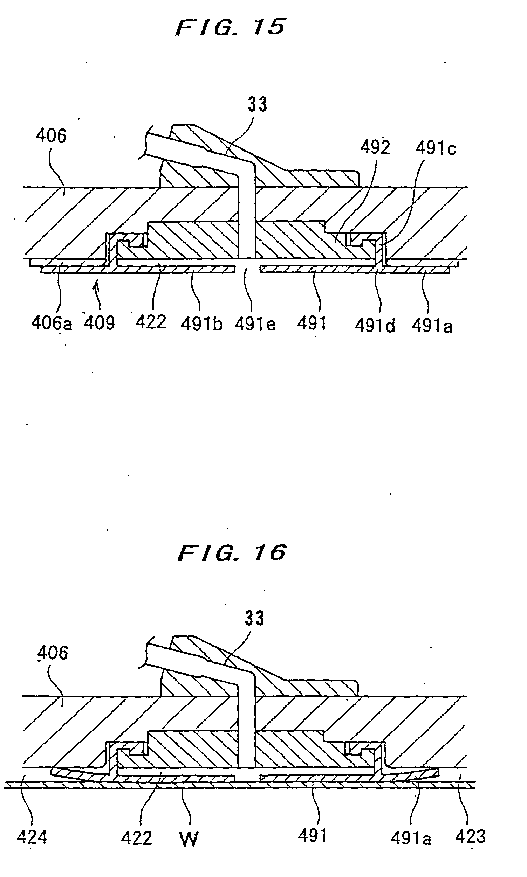

FIG. 15 is a vertical cross-sectional view showing the ring tube 409 shown in FIG. 13. As shown inFIG. 15, the elastic membrane 491 of the ring tube 409 in the present embodiment has an abutment portion 491b having flanges 491a projecting outwardly, and connecting portions 491c connected via the ring tube holder 492 to the chucking plate 406. The connecting portions 491c extend upwardly from the base portions 491d of the flanges 491a. A lower surface of the abutment portion 491b is brought into contact with the upper surface of the semiconductor wafer W. The flanges 491a, the abutment portion 491b, and the connecting portions 491c are integrally made of the same material.

As described above, when the semiconductor wafer is polished, pressurized fluids are supplied to the pressure chamber 422, and the pressure chambers 423, 424 surrounding the ring tube 409. Thus, the flanges 491a are brought into close contact with the semiconductor wafer W by the pressurized fluids supplied to the pressure chambers 423, 424. Accordingly, even if the pressure of the pressurized fluid supplied to the pressure chamber 423 or 424 surrounding the pressure chamber 422 is considerably higher than the pressure of the pressurized fluid supplied to the pressure chamber 422 defined in the ring tube 409, the high-pressure fluid surrounding the pressure chamber 422 is prevented from flowing into the lower portion of the ring tube 409. Therefore, the flanges 491a can widen the range of pressure control in each of the pressure chambers, for thereby pressing the semiconductor wafer more stably.

Openings 491e are formed at a plurality of central portions of the abutment portion 491b of the ring tube 409, and thus a pressurized fluid supplied to the pressure chamber 422 directly contacts with the upper surface of the semiconductor wafer W through the openings 491e of the abutment portion 491b. Since a pressurized fluid is supplied to the pressure chamber 422 during polishing, the pressurized fluid presses the abutment portion 491b of the ring tube 409 against the upper surface of the semiconductor wafer W. Therefore, even if the openings 491e are formed in the abutment portion 491b, a pressurized fluid in the pressure chamber 422 hardly flows out to the exterior of the pressure chamber 422. Further, when the semiconductor wafer W is released, a downward pressure can be applied through the openings 491e to the semiconductor wafer W by a pressurized fluid, so that the semiconductor wafer W can more smoothly be released.

When the pressurized fluid supplied to the intermediate pressure chamber 422 is controlled in temperature and the temperature of the semiconductor wafer W is controlled from the backside of the surface to be polished, as described above, the openings 491e formed in the abutment portion 491b of the ring tube 409 can increase the area in which the pressurized fluid controlled in temperature is brought into contact with the semiconductor wafer W. Therefore, controllability in temperature of the semiconductor wafer W can be improved. Further, when the polishing of the semiconductor wafer W is finished and the semiconductor wafer W is released, the pressure chamber 422 is opened to the outside air via the openings 491e. Thus, the fluid supplied into the pressure chamber 4225 is prevented from remaining in the pressure chamber 422. Therefore, even if semiconductor wafers W are continuously polished, controllability in temperature of the semiconductor wafer W can be maintained.

As shown in FIG. 15, the chucking plate 406 has support portions 406a for supporting the flanges 491a of the ring tube 409. If the chucking plate 406 has no support portions 406a, then the flanges 491a may be deformed and attached to the lower surface of the chucking plate 406 as shown in FIG. 16 when pressurized fluids are supplied to the pressure chambers 423, 424 surrounding the ring tube 409. In such a state, it is impossible to properly control the pressures of the pressure chambers 422 to 424. Accordingly, in the present embodiment, the support portions 406a are provided on the chucking plate 406 for supporting the flanges 491a of the ring tube 409, as described above, to prevent the flanges 491a from being attached to the lower surface of the chucking plate 406 and to stabilize the pressures of the pressure chambers 422 to 424. In this case, when the support portions have radial lengths larger than the radial lengths of the flanges 491a, it is possible to support the flanges 491a more reliably.

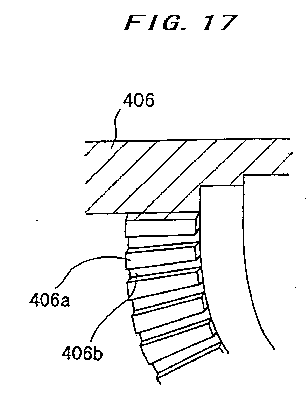

In this case, the flanges 491a of the ring tube 409 are brought into contact with the support portions 406a of the chucking plate 406. In order to enhance adhesiveness of the flanges 491a to the semiconductor wafer W, it is necessary to press the flanges 491a by pressurized fluids supplied to the pressure chambers 423, 424. Accordingly, in the present embodiment, as shown in FIG. 17, fluid introduction grooves 406b are formed in the support portions 406a of the chucking plate 406 for stably pressing the flanges 491a by pressurized fluids supplied to the pressure chambers 423, 424 to enhance adhesiveness between the flanges 491a and the semiconductor wafer W.

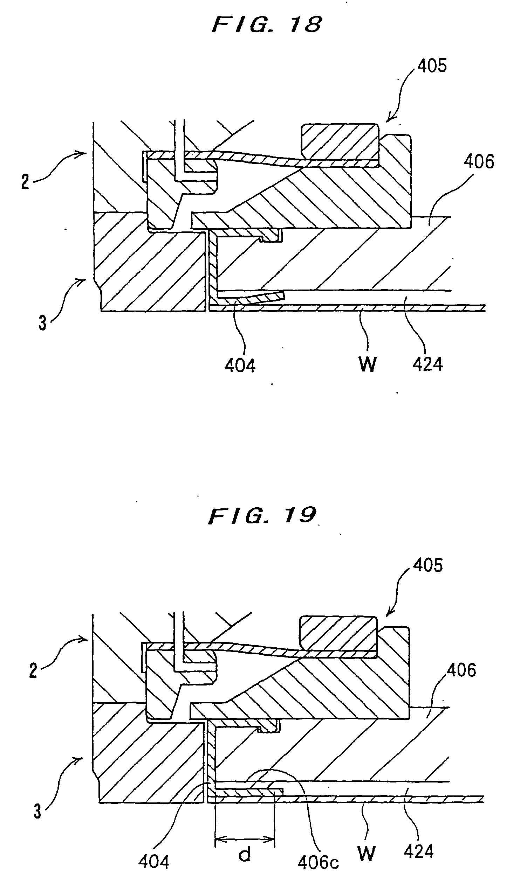

Similarly, with respect to the seal ring 404, the seal ring 404 maybe attached to a peripheral portion of the chucking plate 406 by a pressurized fluid supplied to the pressure chamber 424, as shown in FIG. 18. Accordingly, in the present embodiment, a support portion 406c is provided at the peripheral portion of the chucking plate 406 for supporting the seal ring 404, as shown in FIG. 19. In this case, as with the support portions 406a, fluid introduction grooves may be formed in the support portion 406c for stably pressing the seal ring 404 by a pressurized fluid supplied to the pressure chamber 424 to enhance adhesiveness between the seal ring 404 and the semiconductor wafer W. Further, since such grooves can introduce the pressurized fluid to the outermost portion of the semiconductor wafer, a uniform pressing force can be achieved at the peripheral portion of the wafer.

When the retainer ring 3 is pressed against the polishing pad 101, the polishing pad 101 may be raised (rebounded) near the retainer ring 3 so that a polishing rate is locally increased at the peripheral portion of the semiconductor wafer W. In the present embodiment, the radial length d of the support portion 406c of the chucking plate 406 is shortened to prevent the semiconductor wafer W from being excessively polished at the peripheral portion thereof. When the effects of the rebound are small, the length d is shortened to concentrate the pressing forces, or the length d is lengthened to disperse the pressing forces, for varying polishing rates. Specifically, the length d is varied in a range of 1 mm to 7 mm to achieve desired polishing rates.

In the substrate holding apparatus according to the second embodiment described above, the fluid passages 31, 33, 34 and 35 are provided as separate passages. However, these fluid passages may be combined with each other, or the pressure chambers may be communicated with each other in accordance with the magnitude of the pressing force to be applied to the semiconductor wafer W and the position to which the pressing force is applied. In the above embodiment, the ring tube 409 is brought into direct contact with the semiconductor wafer W. However, the present invention is not limited to such a configuration. For example, an elastic pad may be interposed between the ring tube 409 and the semiconductor wafer W so that the ring tube 409 is brought into indirect contact with the semiconductor wafer W.

In the second embodiment shown in FIGS. 13 through 19, the polishing surface is constituted by the polishing pad. However, the polishing surface is not limited to this. The polishing surface may be constituted by a fixed abrasive as described in the first embodiment shown in FIGS. 2 through 12.

As described above, according to the substrate holding apparatus of the second embodiment of the present invention, pressures to be applied to the substrate can independently be controlled, and hence a pressing force applied to a thicker area of a thin film can be made higher than a pressing force applied to a thinner area of the thin film, thereby selectively increasing the polishing rate of the thicker area of the thin film. Thus, an entire surface of a substrate can be polished exactly to a desired level irrespective of the film thickness distribution obtained at the time the thin film is formed. Further, with a vertically movable member made of a material having a large stiffness and a light weight, e.g., epoxy resin, the vertically movable member becomes unlikely to be bent, so that polishing rates are prevented from being locally increased. Further, when a material having no magnetism is selected as a material of the vertically movable member, it is suitable for cases where the film thickness of a thin film formed on a surface of a semiconductor wafer is measured with a film thickness method using eddy current in such a state that the semiconductor wafer to be polished is held by a top ring.

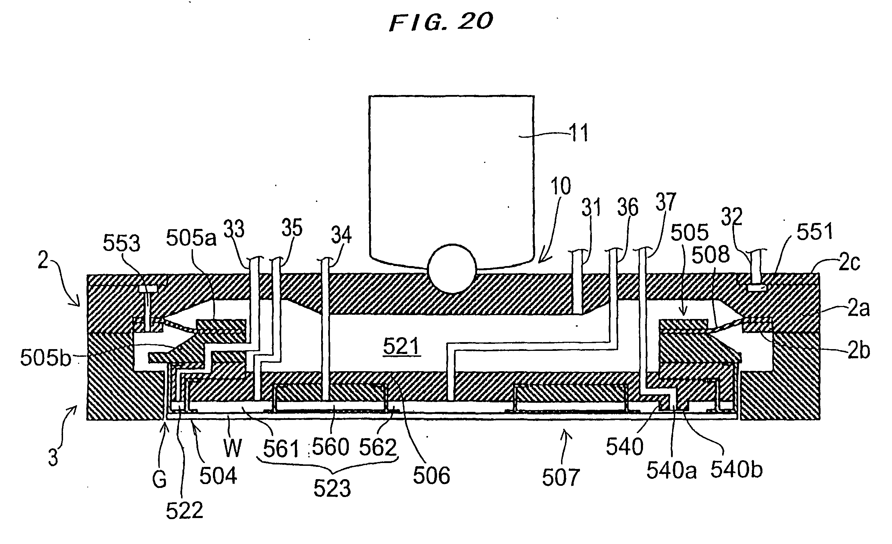

Next, a substrate holding apparatus according to a third embodiment of the present invention will be described below. FIG. 20 is a vertical cross-sectional view showing a top ring 1 according to the third embodiment of the present invention. As shown in FIG. 20, the top ring 1 constituting a substrate holding apparatus comprises a top ring body 2 in the form of a cylindrical housing with a receiving space defined therein, and a retainer ring 3 fixed to the lower end of the top ring body 2. The top ring body 2 is made of a material having high strength and rigidity, such as metal or ceramics. The retainer ring 3 is made of highly rigid synthetic resin, ceramics, or the like.

The top ring body 2 comprises a cylindrical housing 2a, an annular pressurizing sheet support 2b fitted into the cylindrical portion of the housing 2a, and an annular seal 2c fitted over an outer circumferential edge of an upper surface of the housing 2a. The retainer ring 3 is fixed to the lower end of the housing 2a of the top ring body 2. The retainer ring 3 has a lower portion projecting radially inwardly. The retainer ring 3 may be formed integrally with the top ring body 2.

A top ring drive shaft 11 is disposed above the central portion of the housing 2a of the top ring body 2, and the top ring body 2 is coupled to the top ring drive shaft 11 by a universal joint 10. The universal joint 10 has a spherical bearing mechanism by which the top ring body 2 and the top ring drive shaft 11 are tiltable with respect to each other, and a rotation transmitting mechanism for transmitting the rotation of the top ring drive shaft 11 to the top ring body 2. The spherical bearing mechanism and the rotation transmitting mechanism transmit a pressing force and a rotating force from the top ring drive shaft 11 to the top ring body 2 while allowing the top ring body 2 and the top ring drive shaft 11 to be tilted with respect to each other.

The top ring body 2 and the retainer ring 3 secured to the top ring body 2 have a space defined therein, which accommodates therein an edge bag 504 having a lower surface brought into contact with a peripheral portion of the semiconductor wafer W held by the top ring 1, an holder ring 505, a disk-shaped chucking plate 506 which is vertically movable within the receiving space in the top ring body 2, and a torque transmitting member 507 having a lower surface brought into contact with the semiconductor wafer W at a radially inward position of the edge bag 504.

The chucking plate 506 may be made of metal. However, when the thickness of a thin film formed on a surface of a semiconductor wafer is measured by a method using eddy current in such a state that the semiconductor wafer to be polished is held by the top ring, the chucking plate 506 should preferably be made of a non-magnetic material, e.g., an insulating material such as fluororesin or ceramics.

A pressurizing sheet 508 comprising an elastic membrane extends between the holder ring 505 and the top ring body 2. The pressurizing sheet 508 has a radially outer edge clamped between the housing 2a and the pressurizing sheet support 2b of the top ring body 2, and a radially inner edge clamped between an upper end portion 505a and a stopper 505b of the holder ring 505. The top ring body 2, the chucking plate 506, the holder ring 505, and the pressurizing sheet 508 jointly define a pressure chamber 521 in the top ring body 2. As shown in FIG. 20, a fluid passage 31 comprising tubes and connectors communicates with the pressure chamber 521, which is connected to a compressed air source 120 via a regulator R2 provided on the fluid passage 31. The pressurizing sheet 508 is made of a highly strong and durable rubber material such as ethylene propylene rubber (EPDM), polyurethane rubber, or silicone rubber.

A cleaning liquid passage 551 in the form of an annular groove is defined in the upper surface of the housing 2a near its outer circumferential edge over which the seal 2c of the top ring body 2 is fitted. The cleaning liquid passage 551 communicates with a fluid passage 32 via a through-hole formed in the seal 2c, and is supplied with a cleaning liquid (pure water) via the fluid passage 32. A plurality of communication holes 553 are defined in the housing 2a and the pressurizing sheet support 2b in communication with the cleaning liquid passage 551. The communication holes 553 communicate with a small gap G defined between the outer circumferential surface of the edge bag 504 and the inner circumferential surface of the retainer ring 3.

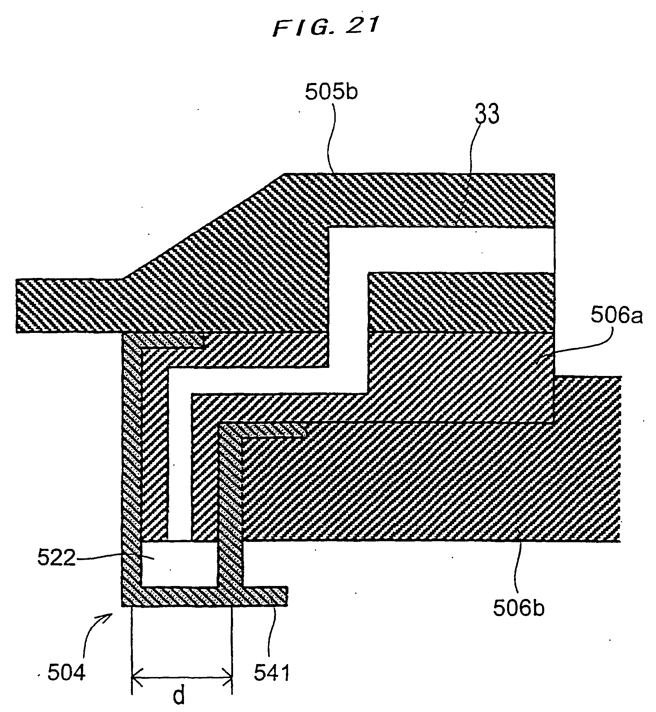

FIG. 21 is a partial cross-sectional view showing the edge bag 504 of FIG. 20. As shown in FIG. 21, the edge bag 504 has a radially outer edge clamped between a stopper 505b of the holder ring 505 and an edge bag holder 506a disposed below the holder ring 505, and a radially inner edge clamped between the edge bag holder 506a and a chucking plate body 506b. The lower end surface of the edge bag 504 is brought into contact with a peripheral portion of the semiconductor wafer W to be polished. The edge bag 504 comprises an elastic membrane made of a highly strong and durable rubber material such as ethylene propylene rubber (EPDM), polyurethane rubber, or silicone rubber.

The lower surface of the edge bag 504 is brought into contact with the peripheral portion of the semiconductor wafer W and provided with a flange 541 projecting radially inwardly. The edge bag 504 has a (first) pressure chamber 522 defined therein by the elastic membrane. A fluid passage 33 comprising tubes and connectors communicates with the pressure chamber 522. The pressure chamber 522 is connected to the compressed air source 120 via a regulator R3 connected to the fluid passages 33.

Upon polishing, the semiconductor wafer W is rotated in accordance with rotation of the top ring 1. Since the aforementioned edge bag 504 has a small contact area with the semiconductor wafer W, rotational torque may fails to completely be transmitted to the semiconductor wafer W. Accordingly, the torque transmitting member 507 is secured to the chucking plate 506 for transmitting sufficient torque to the semiconductor wafer W by abutment with the semiconductor wafer W. The torque transmitting member 507 is in the form of an annular bag and is brought into contact with the semiconductor wafer W with a contact area large enough to transmit sufficient torque to the semiconductor wafer W.

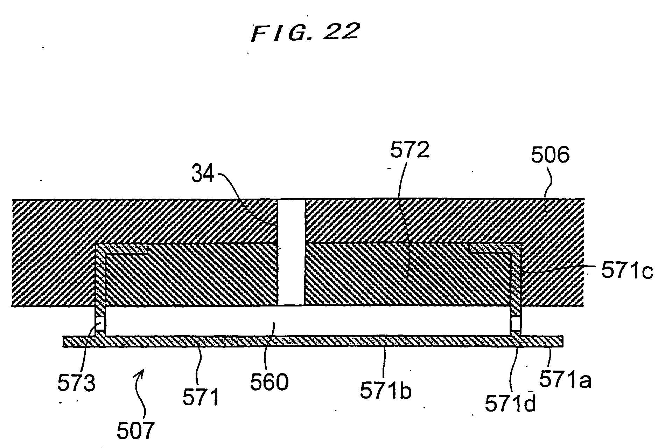

FIG. 22 is a partial cross-sectional view showing the torque transmitting member 507 of FIG. 20. As shown in FIG. 22, the torque transmitting member 507 comprises an elastic membrane 571 brought into contact with the upper surface of the semiconductor wafer W, and a torque transmittingmember holder 572 for detachably holding the elastic membrane 571 in position. The torque transmitting member 507 has a space 560 defined therein by the elastic membrane 571 and the torque transmitting member holder 572. The elastic membrane 571 of the torque transmitting member 507 is made of a highly strong and durable rubber material such as ethylene propylene rubber (EPDM), polyurethane rubber, or silicone rubber, as with the edge bag 504.

As shown in FIG. 22, the elastic membrane 571 of the torque transmitting member 507 has an abutment portion 571b having flanges 571a projecting outwardly, and connecting portions 571c connected via the torque transmitting member holder 572 to the chucking plate 506. The connecting portions 571c extend upwardly from the base portions 571d of the flanges 571a. A lower surface of the abutment portion 571b is brought into contact with the upper surface of the semiconductor wafer W. The connecting portions 571c have a plurality of communication holes 573 provided at radially inward and outward positions, and the interior of the internal space 560 of the torque transmitting member 507 is communicated with external spaces 561, 562.

When the two connecting portions 571c extending vertically are arranged at relatively near positions, the connecting portions 571c have sufficient strength to transmit torque. With the flanges 571a, it is possible to maintain a contact area with the semiconductor wafer W.

The space defined between the chucking plate 506 and the semiconductor wafer W is divided into a plurality of spaces, i.e., a pressure chamber 522 disposed radially inwardly of the edge bag 504, the space 560 in the torque transmitting member 507, a space 561 between the edge bag 504 and the torque transmitting member 507, and a space 562 disposed radially inwardly of the torque transmitting member 507. As described above, the communication holes 573 are provided in the connecting portions 571c of the torque transmitting member 507. Accordingly, the space 561, the space 560, and the space 562 are communicated with each other through the communication holes 573, so that a (second) pressure chamber 523 is formed radially inwardly of the edge bag 504.

A fluid passage 34 comprising tubes and connectors communicates with the space 560 in the torque transmitting member 507. The space 560 is connected to the compressed air source 120 via a regulator R4 connected to the fluid passages 34. A fluid passage 35 comprising tubes and connectors communicates with the space 561 between the edge bag 504 and the torque transmitting member 507. The space 561 is connected to the compressed air source 120 via a regulator R5 connected to the fluid passages 35. A fluid passage 36 comprising tubes and connectors communicates with the space 562 disposed radially inwardly of the torque transmitting member 507. The space 562 is connected to the compressed air source 120 via a regulator (not shown) connected to the fluid passages 36. The pressure chambers 521 to 523 are connected to the respective regulators through a rotary joint (not shown) mounted on the upper end of the top ring shaft 110.

Since the space 561, the space 560, and the space 562 are communicated with each other, as described above, one fluid passage can supply a pressurized fluid so as to uniformly control the pressure of the pressure chamber 523 without a plurality of fluid passages. However, in order to obtain good responsiveness when the pressure of the pressure chamber 523 is varied, it is desirable to provide a plurality of fluid passages 34, 35, 36 as described in the third embodiment. It is not necessary to provide regulators for the respective fluid passages 34, 35, 36, and the fluid passages 34, 35, 36 may be connected to one regulator to control the pressure.

When the semiconductor wafer is polished, pressurized fluids are supplied to the pressure chamber 522 and the pressure chamber 523, respectively. The flange 541 is provided at the lower end surface of the edge bag 504. The flange 541 is brought into close contact with the semiconductor wafer W by the pressurized fluid supplied to the pressure chamber 523. Accordingly, the pressurized fluid in the pressure chamber 523 is prevented from flowing into the lower portion of the edge bag 504. Therefore, the flange 541 can realize a stable control when the pressures of the pressure chamber 522 and the pressure chamber 523 are varied. Here, the radial width d of the elastic membrane defining the pressure chamber 522 in the edge bag 504 should preferably be in a range of from about 1 mm to about 10 mm in view of controlling a polishing rate at a peripheral portion of the semiconductor wafer W, and is set to be 5 mm in the present embodiment.

The pressure chamber 521 above the chucking plate 506 and the pressure chambers 522, 523 are supplied with pressurized fluids such as pressurized air or atmospheric air or evacuated, via the fluid passages 31, 33, 34 to 36 connected to the respective pressure chambers. Specifically, the regulators connected to the fluid passages 31, 33, 34 to 36 of the pressure chambers 521 to 523 can respectively regulate the pressures of the pressurized fluids supplied to the respective pressure chambers. Thus, it is possible to independently control the pressures in the pressure chambers 521 to 523 or independently introduce atmospheric air or vacuum into the pressure chambers 521 to 523. With this arrangement, the pressures of the pressure chambers 523 can press the entire surface of the semiconductor wafer W except the peripheral portion thereof at a uniform force, and the pressure of the pressure chamber 522 can be controlled independently of the pressure of the pressure chamber 523. Therefore, it is possible to control a polishing rate at the peripheral portion of the semiconductor wafer W, i.e., a polishing profile of the peripheral portion of the semiconductor wafer W. Additionally, when the pressing force of the retainer ring 3 is controlled, more detailed control can be achieved.

In this case, the pressurized fluid or the atmospheric air supplied to the pressure chambers 522, 523 may independently be controlled in temperature. With this configuration, it is possible to directly control the temperature of a workpiece such as a semiconductor wafer from the backside of the surface to be polished. Particularly, when each of the pressure chambers is independently controlled in temperature, the rate of chemical reaction can be controlled in the chemical polishing process of CMP.

The chucking plate 506 has suction portions 540 extended downwardly therefrom between the edge bag 504 and the torque transmitting member 507. In the present embodiment, four suction portions 540 are provided. The suction portions 540 have communication holes 540a communicating with a fluid passage 37 comprising tubes and connectors. The suction portions 540 are connected to the compressed air source 120 via a regulator (not shown) connected to the fluid passage 37. The compressed air source 120 can develop a negative pressure at the lower opening ends of the communication holes 540a of the suction portion 540 to attract a semiconductor wafer W to the lower ends of the suction portions 540. The suction portions 540 have elastic sheets 540b, such as thin rubber sheets, attached to their lower ends, for thereby elastically contacting and holding the semiconductor wafer W on the lower surfaces thereof.

Next, operation of the top ring 1 thus constructed will be described in detail below.

In the polishing apparatus constructed above, when a semiconductor wafer W is to be delivered to the polishing apparatus, the top ring 1 as a whole is moved to a position to which the semiconductor wafer W is transferred, and the communication holes 540a of the suctionportions 540 are connected via the fluidpassage 37 to the compressed air source 120. The semiconductor wafer W is attracted under vacuum to the lower ends of the suction portions 540 by suction effect of the communication holes 540a. With the semiconductor wafer W attracted to the top ring 1, the top ring 1 as a whole is moved to a position above the polishing table 100 having the polishing surface (polishing pad 101) thereon. The outer circumferential edge of the semiconductor wafer W is held by the retainer ring 3 so that the semiconductor wafer W is not removed from the top ring 1.

For polishing the semiconductor wafer W, the attraction of semiconductor wafer W by the suction portions 540 is released, and the semiconductor wafer W is held on the lower surface of the top ring 1. Simultaneously, the top ring air cylinder 111 connected to the top ring drive shaft 11 is actuated to press the retainer ring 3 fixed to the lower end of the top ring 1 against the polishing surface on the polishing table 100 under a predetermined pressure. In such a state, pressurized fluids are respectively supplied to the pressure chamber 522 and the pressure chamber 523 under respective pressures, thereby pressing the semiconductor wafer W against the polishing surface on the polishing table 100. The polishing liquid supply nozzle 102 supplies apolishing liquidQ onto thepolishingpad 101 in advance, so that the polishing liquid Q is held on the polishing pad 101. Thus, the semiconductor wafer W is polished by the polishing pad 101 with the polishing liquid Q being present between the (lower) surface, to be polished, of the semiconductor wafer W and the polishing pad 101.

The local areas of the semiconductor wafer W that are positioned beneath the pressure chamber 522 and the pressure chamber 523 are pressed against the polishing surface under the pressures of the pressurized fluids supplied to the pressure chamber 522 and the pressure chamber 523. Therefore, by controlling the pressurized fluids supplied to the pressure chamber 522 and the pressure chamber 523, the polishing pressure applied to the semiconductor wafer W is adjusted so as to press the entire surface of the semiconductor wafer W except the peripheral portion thereof against the polishing surface at a uniform force. Simultaneously, a polishing rate at the peripheral portion of the semiconductor wafer W can be controlled to control a polishing profile of the peripheral portion of the semiconductor wafer W. Similarly, the regulator R2 regulates the pressure of the pressurized fluid supplied to the pressure chamber 521 to change the pressing force to press the retainer ring 3 against the polishing pad 101. In this manner, during polishing, the pressing force to press the retainer ring 3 against the polishing pad 101 and the pressing force to press the semiconductor wafer W against the polishing pad 101 are properly adjusted to control the polishing profile of the peripheral portion of the semiconductor wafer W in great detail. The semiconductor wafer W located below the pressure chamber 523 has an area to which a pressing force is applied via the abutment portion 571b of the torque transmitting member 507 by a fluid, and an area to which a pressure of the pressurized fluid is directly applied. The pressing forces applied to these areas have the same pressure.

As described above, the pressing force applied by the top ring air cylinder 111 to press the retainer ring 3 against the polishing pad 101 and the pressing forces applied by the pressurized fluids supplied to the pressure chamber 522 and the pressure chamber 523 to press the semiconductor wafer W against the polishing pad 101 are appropriately adjusted to polish the semiconductor wafer W. When the polishing of the semiconductor wafer W is finished, the semiconductor wafer W is attracted to the lower ends of the suction portions 540 under vacuum. At this time, the supply of the pressurized fluids into the pressure chamber 522 and the pressure chamber 523 is stopped, and the pressure chamber 522 and the pressure chamber 523 are vented to the atmosphere. Accordingly, the lower ends of the suction portions 540 are brought into contact with the semiconductor wafer W. The pressure chamber 521 is vented to the atmosphere or evacuated to develop a negative pressure therein. This is because if the pressure chamber 521 is maintained at a high pressure, then the semiconductor wafer W is strongly pressed against the polishing surface only in areas brought into contact with the suction portions 540.

After attraction of the semiconductor wafer W, the top ring 1 as a whole is moved to a position to which the semiconductor wafer W is to be transferred, and then a fluid (e.g., compressed air or a mixture of nitrogen and pure water) is ejected to the semiconductor wafer W via the communication holes 540a of the suction portions 540 to release the semiconductor wafer W from the top ring 1.

The polishing liquid Q used to polish the semiconductor wafer W tends to flow through the small gap G between the outer circumferential surface of the edge bag 504 and the retainer ring 3. If the polishing liquid Q is firmly deposited in the gap G, then the holder ring 505, the chucking plate 506, and the edge bag 504 are prevented from smoothly moving vertically with respect to the top ring body 2 and the retainer ring 3. To avoid such a drawback, a cleaning liquid (pure water) is supplied through the fluid passage 32 to the cleaning liquid passage 551. Accordingly, the pure water is supplied via a plurality of communication holes 553 to a region above the gap G, thus cleaning the gap G to prevent the polishing liquid Q from being firmly deposited in the gap G. The pure water should preferably be supplied after the polished semiconductor wafer W is released and until a next semiconductor wafer to be polished is attracted to the top ring 1.

In the third embodiment described above, the fluid passages 31, 33 to 37 are provided as separate passages. However, these fluid passages may be combined with each other, or the pressure chambers may be communicated with each other in accordance with the magnitude of the pressing force to be applied to the semiconductor wafer W and the position to which the pressing force is applied.

In the third embodiment shown in FIGS. 20 through 22, the polishing surface is constituted by the polishing pad. However, the polishing surface is not limited to this. The polishing surface may be constituted by a fixed abrasive, as described in the first embodiment.

As described above, according to the third embodiment of the present invention, sufficient torque can be transmitted to the substrate by the torque transmitting member. Further, the entire surface of the substrate except the peripheral portion thereof can be pressed against the polishing surface at a uniform force by the pressure of the second pressure chamber, and the pressure of the first pressure chamber can be controlled independently of the pressure of the second pressure chamber. Therefore, it is possible to control a polishing rate at the peripheral portion of the semiconductor wafer W, i.e., a polishing profile of the peripheral portion of the semiconductor wafer W.

### Industrial Applicability

The present invention is suitable for use in a substrate holding apparatus for holding a substrate such as a semiconductor wafer in a polishing apparatus for polishing the substrate to a flat finish, and a polishing apparatus having such a substrate holding apparatus.

## Claims

1. A substrate holding apparatus for holding and pressing a substrate to be polished against a polishing surface, **characterized in that**:
said substrate holding apparatus comprises a top ring body having a receiving space therein, and a vertically movable member which is vertically movable within said receiving space in said top ring body;
an abutment member having an elastic membrane is attached to a lower surface of said vertically movable member;
said elastic membrane of said abutment member comprises an abutment portion, having a f lange proj ecting outwardly, brought into direct or indirect contact with the substrate, and a connecting portion extending upwardly from a base portion of said flange of said abutment portion and being connected to said vertically movable member; and
said connecting portion is made of a material having a flexibility higher than said abutment portion.

2. A substrate holding apparatus for holding and pressing a substrate to be polished against a polishing surface, **characterized in that**:
said substrate holding apparatus comprises a top ring body having a receiving space therein, and a vertically movable member which is vertically movable within said receiving space in said top ring body;
an abutment member having an elastic membrane is attached to a lower surface of said vertically movable member;
said elastic membrane of said abutment member comprises an abutment portion, having a flange projecting outwardly, brought into direct or indirect contact with the substrate, and a connecting portion extending upwardly from a base portion of said flange of said abutment portion and being connected to said vertically movable member; and
said connecting portion comprises a thin portion having a thickness smaller than said abutment portion.

3. A substrate holding apparatus according to claim 2, **characterized in that** said thin portion is formed so as to be constricted inwardly in a cross-section.

4. A substrate holding apparatus for holding and pressing a substrate to be polished against a polishing surface, **characterized in that**:
said substrate holding apparatus comprises a top ring body having a receiving space therein, and a vertically movable member which is vertically movable within said receiving space in said top ring body;
an abutment member having an elastic membrane is attached to a lower surface of said vertically movable member;
said elastic membrane of said abutment member comprises an abutment portion, having a flange projecting outwardly, brought into direct or indirect contact with the substrate, and a connecting portion extending upwardly from a base portion of said flange of said abutment portion and being connected to said vertically movable member; and
adhesiveness of a lower surface of said base portion of said flange of said abutment portion is weakened.

5. A substrate holding apparatus according to claim 4, **characterized in that** an intermediate member having a low adhesiveness to the substrate is disposed on said lower surface of said base portion of said flange of said abutment portion to weaken adhesiveness of said lower surface of said base portion of said flange.

6. A substrate holding apparatus for holding and pressing a substrate to be polished against a polishing surface, **characterized in that**:
said substrate holding apparatus comprises a top ring body having a receiving space therein, and a vertically movable member which is vertically movable within said receiving space in said top ring body;
an abutment member having an elastic membrane is attached to a lower surface of said vertically movable member;
said elastic membrane of said abutment member comprises an abutment portion, having a flange projecting outwardly, brought into direct or indirect contact with the substrate, and a connecting portion extending upwardly from a base portion of said flange of said abutment portion and being connected to said vertically movable member; and
a hard member made of a material harder than said elastic membrane is embedded in said base portions of said flange of said abutment portion.

7. A substrate holding apparatus according to claim 6, **characterized in that** said hard member has an annular shape.

8. A substrate holding apparatus for holding and pressing a substrate to be polished against a polishing surface, **characterized in that**:
said substrate holding apparatus comprises a top ring body having a receiving space therein, and a vertically movable member which is vertically movable within said receiving space in said top ring body;
an abutment member having an elastic membrane is attached to a lower surface of said vertically movable member; and
said elastic membrane of said abutment member comprises an abutment portion, havinga flange projecting outwardly, brought into direct or indirect contact with the substrate, an extending portion extending outwardly from a base portion of said flange to a position inward of a tip of said flange to form a groove between said extending portion and said flange of said abutment portion, and a connecting portion extending upwardly from an outward end of said extending portion and being connected to said vertically movable member.

9. A substrate holding apparatus according to any one of claims 1 through 8, **characterized in that** said connecting portion positioned radially inwardly and said connecting portion positioned radially outwardly have different thicknesses.

10. A substrate holding apparatus according to claim 9, **characterized in that** said connecting portion positioned radially inwardly has a thickness smaller than said connecting portion positioned radially outwardly.

11. A substrate holding apparatus according to any one of claims 1 through 10, **characterized in that** said flange projecting radially outwardly and said flange projecting radially inwardly have different lengths.

12. A substrate holding apparatus according to claim 11, **characterized in that** said flange projecting radially outwardly has a length larger than said flange proj ecting radially inwardly.

13. A substrate holding apparatus for holding and pressing a substrate to be polished against a polishing surface, **characterized in that**:
said substrate holding apparatus comprises a top ring body having a receiving space therein, and a vertically movable member which is vertically movable within said receiving space in said top ring body;
an abutment member having an elastic membrane which is brought into direct or indirect contact with the substrate is attached to a lower surface of said vertically movable member; and
said vertically movable member is made of a material having a large stiffness.

14. A substrate holding apparatus for holding and pressing a substrate to be polished against a polishing surface, **characterized in that**:
an abutment member having an elastic membrane is attached to a lower surface of a top ring;
said elastic membrane of said abutment member comprises an abutment portion, having a flange projecting outwardly, brought into direct or indirect contact with the substrate, and a connecting portion extending upwardly from a base portion of said flange of said abutment portion and being connected to said top ring; and
said top ring has a support portion for supporting said flange of said abutment member.

15. A substrate holding apparatus according to claim 14, **characterized in that** said support portion has a radial length larger than a radial length of said flange of said abutment member.

16. A substrate holding apparatus according to claim 14 or 15, **characterized in that** a fluid introduction groove for introducing a fluid into an upper surface of said flange of said abutment member is formed in said support portion.

17. A substrate holding apparatus for holding and pressing a substrate to be polished against a polishing surface, **characterized in that**:
said substrate holding apparatus comprises a top ring body having a receiving space therein, a vertically movable member which is vertically movable within said receiving space in said top ring body, and a seal ring being brought into contact with an upper surface of a peripheral portion of the substrate; and
said vertically movable member has a support portion for supporting said seal ring, said support portion having a radial length in a range of from 1 mm to 7 mm.

18. A substrate holding apparatus according to claim 17, **characterized in that** a fluid introduction groove for introducing a fluid into an upper surface of said seal ring is formed in said support portion of said vertically movable member.

19. A substrate holding apparatus for holding and pressing a substrate to be polished against a polishing surface, **characterized in that**:
said substrate holding apparatus comprises a top ring body for holding the substrate, an edge bag being brought into contact with a peripheral portion of the substrate, a torque transmitting member being brought into contact with the substrate radially inwardly of said edge bag; and
a pressure of a first pressure chamber defined in said edge bag and a pressure of a second pressure chamber defined radially inwardly of said edge bag are independently controlled.

20. A substrate holding apparatus according to claim 19, **characterized in that** said torque transmitting member has a communication hole communicating a space inside of said torque transmitting member and a space outside of said torque transmitting member with each other.

21. A substrate holding apparatus according to claim 19 or 20, **characterized in that** said edge bag defining said first pressure chamber comprises a member having a radial width in a range of from 1 mm to 10 mm.

22. A substrate holding apparatus according to any one of claims 19 through 21, **characterized in that**:
said substrate holding apparatus comprises a retainer ring secured to or formed integrally with said top ring body for holding a side edge portion of the substrate; and
a pressing force to press said retainer ring against the polishing surface is controlled independently of a pressure of said pressure chamber.

23. A polishing apparatus **characterized by** comprising a substrate holding apparatus according to any one of claims 1 through 22, and a polishing table having a polishing surface.
